# EUROPEAN PATENT APPLICATION

(11) **EP 4 770 402 A2**
(43) Date of publication of application: **01.07.2026**
(21) Application number: 25223389.5
(22) Date of filing: 15.12.2025
(51) Int. Cl.: H10P 72/00

(54) **SUBSTRATE PROCESSING APPARATUS AND SUBSTRATE PROCESSING METHOD**

(30) Priority: 24.12.2024 JP 2024227801
(71) Applicant: SCREEN Holdings Co., Ltd., Kyoto-shi, Kyoto 602-8585 (JP)
(72) Inventor: ENDO, Toru, Kyoto, 602-8585 (JP)
(74) Representative: Kilian Kilian & Partner mbB

(57) **Abstract**

A substrate processing apparatus includes a nozzle device having a liquid discharger, a fluid supply system that supplies a processing liquid having a surface tension lower than that of a residual liquid to the nozzle device, a horizontal-direction driving device that moves the nozzle device to a plurality of different portions in a radial direction of a substrate in plan view while keeping the nozzle device at a position above the rotating substrate, and a controller that controls the fluid supply system and the horizontal-direction driving device according to a liquid processing condition. A liquid processing condition includes a liquid flow-rate condition that defines a flow rate of a processing liquid to be supplied to the nozzle device in each of the plurality of portions of the substrate, and a liquid movement condition that defines a movement speed of the nozzle device when the nozzle device moves to each of the plurality of portions of the substrate in order to supply the processing liquid to each of the plurality of portions of the substrate.

## Description

### BACKGROUND

### Technical Field

The present disclosure relates to a substrate processing apparatus and a substrate processing method for executing a predetermined process on a substrate.

### Description of Related Art

A substrate processing apparatus is used to execute various processes on a substrate such as a semiconductor substrate, a substrate for an FPD (Flat Panel Display) that is used for a liquid crystal display device, an organic EL (Electro Luminescence) display device or the like, a substrate for an optical disc, a substrate for a magnetic disc, a substrate for a magneto-optical disc, a substrate for a photomask, a ceramic substrate or a substrate for a solar cell.

In a process of manufacturing a semiconductor device, a pattern of a photosensitive resist is formed on a substrate by using photolithography, for example. Various patterns such as wiring circuits are formed on the substrate by supply of a chemical liquid onto the substrate on which the photosensitive resist is formed (chemical liquid process).

A rinsing process is executed to stop the progress of the chemical liquid process and remove the chemical liquid remaining on the substrate after pattern formation. In the rinsing process, a rinse liquid is supplied onto the substrate after the chemical liquid process. Thus, the chemical liquid on the substrate is replaced with the rinse liquid. Thereafter, a drying process of removing the rinse liquid remaining on the substrate is executed. JP 2017-157800 A describes a substrate processing system capable of sequentially executing the chemical liquid process, the rinsing process and the drying process, described above, in one processing unit.

### SUMMARY

In the processing unit described in JP 2017-157800 A, a chemical liquid process is executed on a substrate that is held and rotated by a substrate holding mechanism. During the rinsing process after the chemical liquid process, a predetermined amount of De-ionized water (DIW) is supplied as a rinsing liquid to the upper surface of the substrate. After the rinsing process, Isopropyl Alcohol (IPA) is supplied onto the substrate as a drying liquid. Thus, the DIW on the substrate is sequentially replaced with the IPA. The IPA supplied onto the substrate splashes sidewardly of the substrate due to a centrifugal force. Thus, a dry area is formed in the center portion of the upper surface of the substrate. The N₂ gas is supplied to the dry area, so that it promotes drying for the substrate.

In a series of processes, described above, since a nozzle is moved relative to the substrate while fluid is supplied onto the substrate from the corresponding nozzle, the respective fluids of the IPA and the N₂ gas are supplied to the entire surface of the substrate.

Meanwhile, excessive consumption of fluid resources such as IPA and N₂ gas, not limited to the chemical liquid and DIW, increases the cost required for a process for the substrate. Further, from the viewpoint of environmental protection, it is not preferable that the consumption of an organic solvent such as IPA increases. On the other hand, even in a case in which the use amount of fluids such as IPA and N₂ gas is simply reduced, when a process cannot be executed on the substrate with high accuracy, the manufacturing yield of the substrate is reduced.

An object of the present disclosure is to provide a substrate processing apparatus and a substrate processing method that enable execution of a process on a substrate with high accuracy while suppressing consumption of fluid resources used for the process for the substrate after pattern formation.

A substrate processing apparatus according to one aspect of the present disclosure that removes a residual liquid remaining on a substrate after pattern formation from the substrate, includes a rotation driver that rotates a substrate holder holding the substrate, a nozzle device having a liquid discharger, a fluid supply system that supplies a processing liquid to the nozzle device, with the processing liquid having a surface tension lower than that of the residual liquid, a movement driver that moves the nozzle device having one posture to a plurality of different portions in a radial direction of the substrate in plan view while keeping the nozzle device at a position above the substrate held by the substrate holder, and a controller that controls the fluid supply system and the movement driver according to a liquid processing condition, wherein with the nozzle device having the one posture, the liquid discharger is formed to downwardly discharge the processing liquid supplied from the fluid supply system, and the liquid processing condition includes a liquid flow-rate condition that defines a flow rate of the processing liquid to be supplied to the nozzle device in each of the plurality of portions, and a liquid movement condition that defines a movement speed of the nozzle device when the nozzle device moves to each of the plurality of portions in order to supply the processing liquid to each of the plurality of portions of the substrate.

A substrate processing apparatus according to another aspect of the present disclosure that removes a processing liquid remaining on a substrate after pattern formation and dries the substrate, includes a rotation driver that rotates a substrate holder holding the substrate, a nozzle device having a first gas injector, a fluid supply system that supplies a first gas to the nozzle device, a movement driver that moves the nozzle device having one posture to a plurality of different portions in a radial direction of the substrate in plan view while keeping the nozzle device at a position above the substrate held by the substrate holder, and a controller that controls the fluid supply system and the movement driver according to a gas processing condition, wherein the first gas injector is formed to downwardly inject the first gas supplied from the fluid supply system with the nozzle device having the one posture, and the gas processing condition includes a gas flow-rate condition that defines a flow rate of the first gas to be supplied to the nozzle device in each of the plurality of portions, and a gas movement condition that defines a movement speed of the nozzle device when the nozzle device moves to each of the plurality of portions in order to supply the first gas to each of the plurality of portions of the substrate.

A substrate processing method according to yet another aspect of the present disclosure of removing a residual liquid from a substrate using a nozzle device, with the residual liquid remaining on the substrate after pattern formation, wherein the nozzle device has a liquid discharger, the liquid discharger is formed to downwardly discharge a processing liquid supplied to the nozzle device with the nozzle device having one posture, the processing liquid has a surface tension lower than that of the residual liquid, the substrate processing method includes the steps of holding and rotating the substrate using a substrate holder, and according to a liquid processing condition, moving the nozzle device having the one posture to a plurality of different portions in a radial direction of the substrate in plan view and supplying the processing liquid to the plurality of portions of the substrate while keeping the nozzle device at a position above the substrate held by the substrate holder, and the liquid processing condition includes a liquid flow-rate condition that defines a flow rate of a processing liquid to be supplied to the nozzle device in each of the plurality of portions, and a liquid movement condition that defines a movement speed of the nozzle device when the nozzle device moves to each of the plurality of portions in order to supply a processing liquid to each of the plurality of portions of the substrate.

A substrate processing method according to yet another aspect of the present disclosure of removing a processing liquid and drying a substrate using a nozzle device, with the processing liquid remaining on the substrate after pattern formation, wherein the nozzle device has a gas injector, the gas injector is formed to downwardly inject a first gas supplied to the nozzle device with the nozzle device having one posture, the substrate processing method includes the steps of holding and rotating the substrate using a substrate holder, and according to a gas processing condition, moving the nozzle device having the one posture to a plurality of different portions in a radial direction of the substrate in plan view and injecting the first gas to the plurality of portions of the substrate while keeping the nozzle device at a position above the substrate held by the substrate holder, and the gas processing condition includes a gas flow-rate condition that defines a flow rate of the first gas to be supplied to the nozzle device in each of the plurality of portions, and a gas movement condition that defines a movement speed of the nozzle device when the nozzle device moves to each of the plurality of portions in order to supply the first gas to each of the plurality of portions of the substrate.

With the present disclosure, it is possible to execute a process on a substrate with high accuracy while suppressing the consumption of fluid resources used for the process for the substrate after pattern formation.

Other features, elements, characteristics, and advantages of the present disclosure will become more apparent from the following description of preferred embodiments of the present disclosure with reference to the attached drawings.

### BRIEF DESCRIPTION OF THE DRAWING

Fig. 1 is a schematic side view of a substrate processing apparatus according to one embodiment of the present disclosure;
Fig. 2 is a schematic plan view showing the inner configuration of the substrate processing apparatus of Fig. 1;
Fig. 3 is a schematic external perspective view of a nozzle device of Fig. 1;
Fig. 4 is a schematic plan view of the nozzle device of Fig. 1;
Fig. 5 is a longitudinal cross-sectional view of the nozzle device of Fig. 4 taken along the line Q-Q;
Fig. 6 is a block diagram showing the outline of configuration of a control system of the substrate processing apparatus of Fig. 1;
Fig. 7 is a plan view showing one example of a plurality of divided areas defined on an upper surface of a substrate W to be processed;
Fig. 8 is a diagram showing one example of a liquid processing condition;
Fig. 9 is a diagram showing one example of a gas processing condition;
Fig. 10 is a block diagram for explaining one example configuration of functions for control based on a liquid processing condition and a gas processing condition;
Fig. 11 is a flowchart showing a flow of process executed by the plurality of functions of Fig. 10;
Fig. 12 is a flowchart showing a flow of process executed by the plurality of functions of Fig. 10;
Fig. 13 is a time chart for explaining one example of the work of each constituent element in a case in which a series of processes is executed on a substrate using the substrate processing apparatus of Fig. 1;
Fig. 14 is a schematic side view showing the work of each constituent element of the substrate processing apparatus according to the time chart of Fig. 13;
Fig. 15 is a schematic side view showing the work of each constituent element of the substrate processing apparatus according to the time chart of Fig. 13;
Fig. 16 is a schematic side view showing the work of each constituent element of the substrate processing apparatus according to the time chart of Fig. 13;
Fig. 17 is a schematic side view showing the work of each constituent element of the substrate processing apparatus according to the time chart of Fig. 13;
Fig. 18 is a schematic side view showing the work of each constituent element of the substrate processing apparatus according to the time chart of Fig. 13;
Fig. 19 is a schematic side view showing the work of each constituent element of the substrate processing apparatus according to the time chart of Fig. 13;
Fig. 20 is a schematic side view showing the work of each constituent element of the substrate processing apparatus according to the time chart of Fig. 13;
Fig. 21 is a schematic side view showing the work of each constituent element of the substrate processing apparatus according to the time chart of Fig. 13;
Fig. 22 is a schematic side view showing the work of each constituent element of the substrate processing apparatus according to the time chart of Fig. 13;
Fig. 23 is a schematic side view showing the work of each constituent element of the substrate processing apparatus according to the time chart of Fig. 13;
Fig. 24 is a schematic side view showing the work of each constituent element of the substrate processing apparatus according to the time chart of Fig. 13;
Fig. 25 is a schematic plan view showing one example of a substrate processing system including the substrate processing apparatus of Fig. 1;
Fig. 26 is a schematic side view of a substrate processing apparatus according to another embodiment;
Fig. 27 is a diagram showing one example of a temperature adjustment condition;
Fig. 28 is a block diagram for explaining one example configuration of functions for control based on a liquid processing condition, a gas processing condition and a temperature adjustment condition;
Fig. 29 is a flowchart showing a flow of process executed by the plurality of functions of Fig. 28;
Fig. 30 is a schematic side view of a substrate processing apparatus according to yet another embodiment;
Fig. 31 is a diagram showing one example of a gas emitting condition;
Fig. 32 is a block diagram for explaining one example configuration of functions for control based on a liquid processing condition, a gas processing condition and a gas emitting condition; and
Fig. 33 is a flowchart showing a flow of process executed by the plurality of functions of Fig. 32.

### DETAILED DESCRIPTION

A substrate processing apparatus and a substrate processing method according to one embodiment of the present disclosure will be described below with reference to the drawings. In the following description, a substrate refers to a substrate for a Flat Panel Display (FPD) that is used for a liquid crystal display device, an organic Electro Luminescence (EL) display device or the like, a semiconductor substrate, a substrate for an optical disc, a substrate for a magnetic disc, a substrate for a magneto-optical disc, a substrate for a photomask, a ceramic substrate, a substrate for a solar cell or the like. Further, an upper surface of the substrate refers to a surface of the substrate directed upwardly, and a lower surface of the substrate refers to a surface directed downwardly. The upper surface of the substrate may be a circuit forming surface (obverse surface), or the surface opposite to the circuit forming surface (back surface). Further, the substrate has a circular shape except for a notch in plan view.

Further, the substrate processing apparatus described below executes a chemical liquid process, a rinsing process and a drying process on a substrate to be processed. In the present embodiment, the chemical liquid process is a process of forming the structure of a predetermined pattern on the upper surface of the substrate by supplying a chemical liquid to the upper surface of the substrate. Further, the rinsing process is a process of washing the chemical liquid off the upper surface of the substrate by supplying a rinse liquid to the upper surface of the substrate after the chemical liquid process. Further, the drying process is a process of, by supplying a processing liquid having a surface tension lower than that of the rinse liquid to the upper surface of the substrate after the rinsing process, replacing the rinse liquid remaining on the substrate with the processing liquid and then drying the substrate. In the following description, the processing liquid used in the drying process, that is, the processing liquid having a surface tension lower than that of the rinse liquid is referred to as a replacement liquid.

### 1. Outline of Configuration of Substrate Processing Apparatus

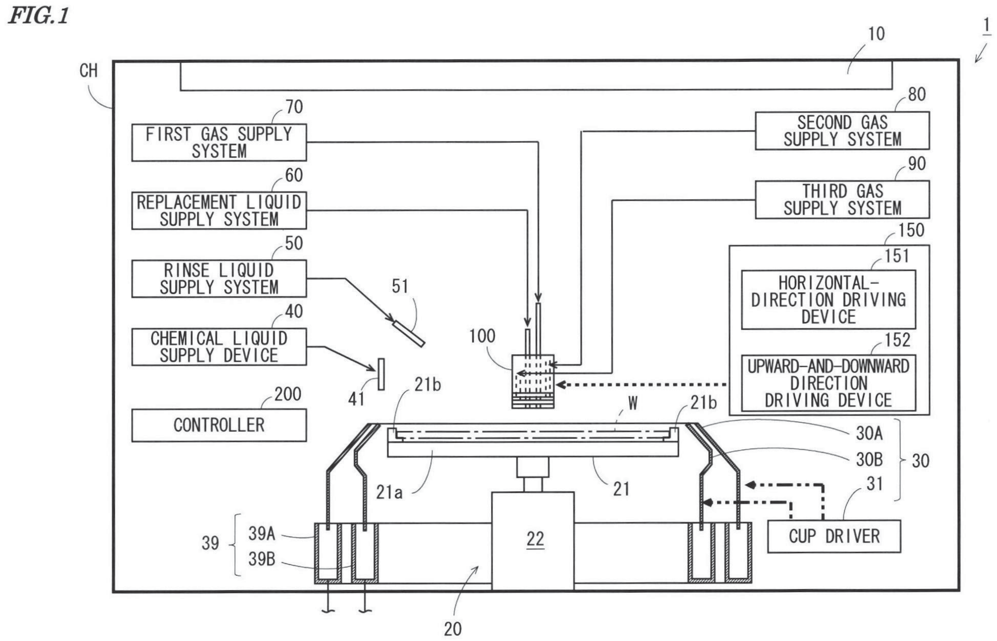

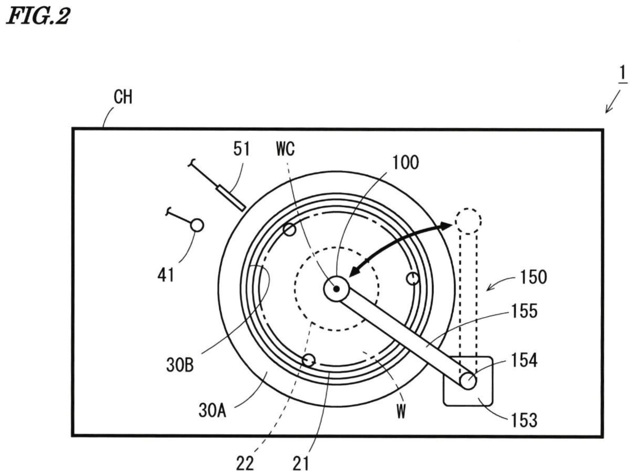

Fig. 1 is a schematic side view of the substrate processing apparatus according to the one embodiment of the present disclosure. Fig. 2 is a schematic plan view of the inner configuration of the substrate processing apparatus 1 of Fig. 1. Fig. 2 shows only part of a plurality of constituent elements of the substrate processing apparatus 1 of Fig. 1. As shown in Fig. 1, the substrate processing apparatus 1 includes a substrate holding device 20, a cup device 30, a liquid drain device 39, a chemical liquid supply device 40, a rinse liquid supply system 50 and a replacement liquid supply system 60. Further, the substrate processing apparatus 1 includes a first gas supply system 70, a second gas supply system 80, a third gas supply system 90, a nozzle device 100, a nozzle movement device 150 and a controller 200.

Further, the substrate processing apparatus 1 includes a chamber CH that accommodates the above-mentioned respective constituent elements. The chamber CH has four side surface portions, a ceiling portion and a bottom portion. In one side surface portion of the chamber CH, a transfer opening (not shown) for transferring a substrate between the inside of the chamber CH and the outside of the chamber CH is formed. Further, a Filter Fan Unit (FFU) 10 is provided in the ceiling portion of the chamber CH. In the chamber CH, the FFU10 generates a downward flow of clean air.

The substrate holding device 20 is provided at substantially the center of the bottom portion of the chamber CH. The substrate holding device 20 includes a substrate holder 21 and a rotation driver 22. The rotation driver 22 is a motor, for example, and is fixed to a bottom portion of the chamber CH. The rotation driver 22 has a rotation shaft extending upwardly. The substrate holder 21 is connected to the upper end portion of the rotation shaft.

The substrate holder 21 is a so-called mechanical chuck-type spin chuck that holds the outer peripheral end of the substrate W. Specifically, the substrate holder 21 includes a disc-shaped spin base 21a and a plurality of rotary holding pins 21b provided on the peripheral portion of the upper surface of the spin base 21a. In the substrate holder 21, the peripheral portion of the lower surface and the outer peripheral end of the substrate W arranged on the spin base 21a are held by the plurality of holding pins 21b. In this state, the rotation driver 22 works to rotate the substrate W in a horizontal attitude. In Figs. 1 and 2, the substrate W held by the substrate holding device 20 is indicated by the one-dot and dash lines.

The chemical liquid process, the rinsing process and the drying process, described above, are executed when various processing liquids are supplied to the upper surface of the substrate W held and rotated by the substrate holding device 20. The cup device 30 and the liquid drain device 39 are used to discard various liquids splashed from the rotating substrate W during each process.

The cup device 30 includes an outer cup 30A, an inner cup 30B and a cup driver 31. Each of the outer cup 30A and the inner cup 30B has a substantially cylindrical shape, and is provided to surround the substrate holder 21 in plan view (Fig. 2) and extend in an upward-and-downward direction (e.g., a vertical direction.) The inner diameter of the outer cup 30A is larger than the outer diameter of the inner cup 30B. Therefore, the inner cup 30B is arranged inside of the outer cup 30A. Further, each of the outer cup 30A and the inner cup 30B is provided to be movable in the upward-and-downward direction.

The cup driver 31 includes an actuator such as a motor or an air cylinder. The cup driver 31 moves each of the outer cup 30A and the inner cup 30B between a predetermined cup upper position and a predetermined cup lower position according to a process executed on the substrate W.

The cup upper position of each of the cups 30A, 30B is the height position (position in the upward-and-downward direction) at which the upper end portion of the cup is higher than the substrate W held by the substrate holder 21. Thus, each cup receives the processing liquid splashed from the substrate W while being located at the cup upper position. On the other hand, the cup lower position of each of the cups 30A, 30B is the height position at which the upper end portion of the cup is lower than the substrate W held by the substrate holder 21. In the present embodiment, the cup upper position of the outer cup 30A and the cup upper position of the inner cup 30B are the same. Further, the cup lower position of the outer cup 30A and the cup lower position of the inner cup 30B are the same.

The liquid drain device 39 includes an outer container 39A and an inner container 39B respectively corresponding to the outer cup 30A and the inner cup 30B. Each of the outer container 39A and the inner container 39B has an annular groove opening upwardly, and guides the liquid received by the corresponding cup to a disposal facility in a factory.

A chemical liquid nozzle 41 is provided in the chamber CH. The chemical liquid supply device 40 includes a chemical liquid supply system and a chemical liquid nozzle movement device (not shown). The chemical liquid nozzle 41 is supported by the chemical liquid nozzle movement device. During the chemical liquid process for the substrate W, the chemical liquid nozzle movement device moves the chemical liquid nozzle 41 between a processing position above the center WC (Fig. 2) of the substrate W held by the substrate holder 21 and a waiting position sideward of the substrate W. During the chemical liquid process for the substrate W, the chemical liquid supply system of the chemical liquid supply device 40 supplies a chemical liquid to the chemical liquid nozzle 41 being located at the processing position. Thus, the chemical liquid is supplied to the upper surface of the rotating substrate W held by the substrate holder 21.

As the chemical liquid, hydrofluoric acid (HF), a sulfuric acid-hydrogen peroxide mixture (SPM), an ammonia-hydrogen peroxide mixture (SC1), a hydrochloric acid-hydrogen peroxide mixture (SC2), dilute hydrofluoric acid (DHF), an organic alkali (tetramethylammonium hydroxide (TMAH), for example), buffered hydrofluoric acid (BHF) or the like, is used.

In the chamber CH, a rinse liquid nozzle 51 is further provided at a predetermined position higher than the substrate holding device 20 and the cup device 30. The rinse liquid nozzle 51 is fixed such that its discharge port is directed to the center WC of the substrate W held by the substrate holder 21. During the rinsing process for the substrate W, the rinse liquid supply system 50 supplies a rinse liquid to the rinse liquid nozzle 51. Thus, the rinse liquid is supplied to the upper surface of the rotating substrate W held by the substrate holder 21.

As the rinsing liquid, a pure water (deionized water), a carbonated water, an ozonated water, a magnetic water, an ultra-dilute ammonium water (not less than 1 ppm and not more than 100 ppm), an ultra-dilute hydrochloric acid water (not less than 1 ppm and not more than 100 ppm), a kangen water (hydrogen water), an ionized water or the like.

The nozzle device 100 is supported by the nozzle movement device 150 in the chamber CH. As shown in Fig. 2, the nozzle movement device 150 includes a base portion 153, a support shaft 154 and an arm 155. The base portion 153 is fixed to the bottom portion of the chamber CH so as to be located outwardly of the outer cup 30A in plan view. The support shaft 154 is provided so as to extend upwardly from the base portion 153 by a certain distance. The arm 155 extending in a horizontal direction is attached to the upper end portion of the support shaft 154. The nozzle device 100 is attached to the tip portion of the arm 155.

As shown in Fig. 1, the nozzle movement device 150 further includes a horizontal-direction driving device 151 and an upward-and-downward direction driving device 152. Each of the horizontal-direction driving device 151 and the upward-and-downward direction driving device 152 is built in the base portion 153 of Fig. 2, for example, and includes an actuator such as a motor or an air cylinder.

The horizontal-direction driving device 151 rotates the support shaft 154 about the axis of the support shaft 154 during the drying process for the substrate W. Thus, the nozzle device 100 moves between a space above the substrate W held by the substrate holder 21 and the waiting position sideward of the substrate W so as to draw an arc in plan view (see the thick solid arrow in Fig. 2).

Further, the upward-and-downward direction driving device 152 moves the support shaft 154 in the upward-and-downward direction. Thus, during the drying process for the substrate W, the horizontal-direction driving device 151 moves the nozzle device 100 between a nozzle upper position and a nozzle lower position in the space above the substrate W held by the substrate holder 21.

In the following description, a height position of the nozzle device 100 means a height position of the lower end portion of the nozzle device 100. The nozzle upper position is a height position higher than the cup upper position of the outer cup 30A and the inner cup 30B and higher than the substrate W held by the substrate holder 21 by a predetermined distance (about 30 mm, for example). The nozzle lower position is a height position lower than the nozzle upper position and higher than the substrate W held by the substrate holder 21.

During the drying process for the substrate W, the replacement liquid supply system 60, the first gas supply system 70, the second gas supply system 80 and the third gas supply system 90 respectively supply the replacement liquid, a first gas, a second gas and a third gas to the nozzle device 100.

As described above, the replacement liquid is a processing liquid having a surface tension lower than that of the rinse liquid used in the rinsing process executed immediately before the drying process. An organic solvent is used as such a processing liquid. In the present embodiment, isopropyl alcohol (IPA) is used as the replacement liquid. As the replacement liquid, instead of IPA, other organic solvents such as hydrofluoroether (HFE), methanol, ethanol or acetone may be used. Further, the replacement liquid may be a liquid mixture of an organic solvent and a pure water.

In the present embodiment, the first gas, the second gas and the third gas are a nitrogen gas. Note that the first gas, the second gas and the third gas are only required to be an inert gas. An argon gas, a helium gas or the like can be used instead of a nitrogen gas. Further, the first gas, the second gas and the third gas may be an inert gas of the same type, or at least one of the gases may be an inert gas having a type different from the types of the other gases.

The controller 200 controls the respective components of the substrate processing apparatus 1 such that the chemical liquid process, the rinsing process and the drying process are executed on the substrate W. Details of the controller 200 will be described below.

### 2. Configuration of Nozzle Device 100

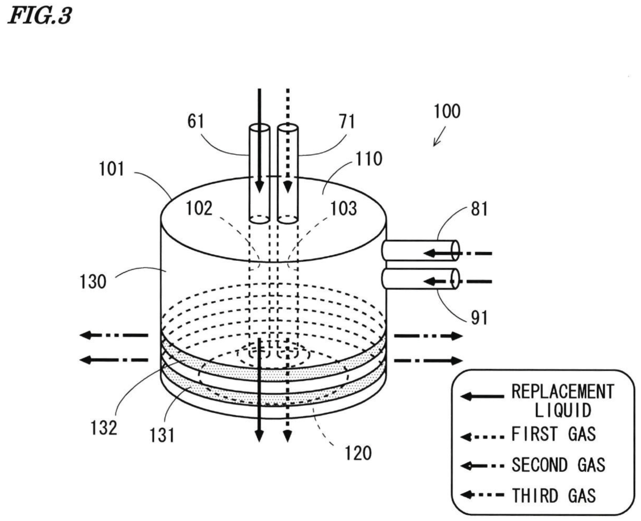

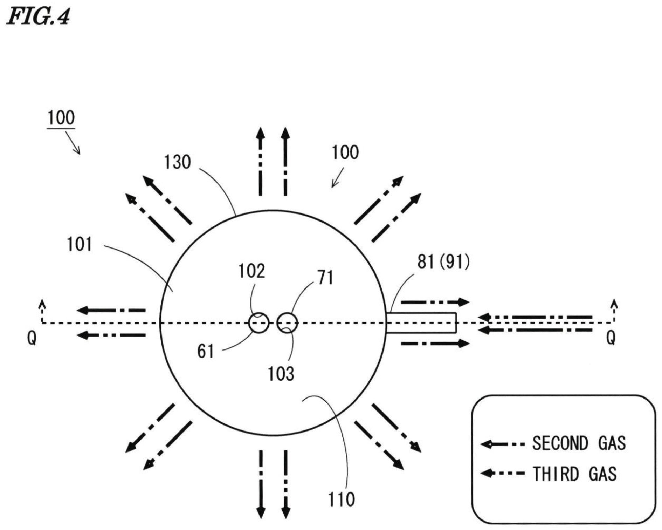

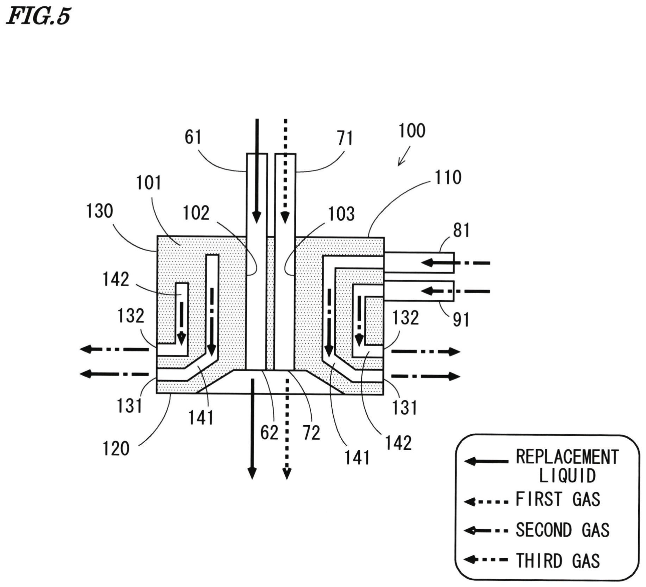

The configuration of the nozzle device 100 will be described. Fig. 3 is a schematic external perspective view of the nozzle device 100 of Fig. 1, Fig. 4 is a schematic plan view of the nozzle device 100 of Fig. 1, and Fig. 5 is a longitudinal cross-sectional view of the nozzle device 100 of Fig. 4 taken along the line Q-Q.

As shown in Fig. 3, the nozzle device 100 includes a nozzle body 101 having a substantially columnar shape. In the substrate processing apparatus 1, the nozzle device 100 is supported by the nozzle movement device 150 while having one posture in which the axial center (center axis) of the nozzle body 101 extends in the upward-and-downward direction.

The nozzle body 101 has an upper surface 110, a lower surface 120 and an outer peripheral surface 130. The upper surface 110 has a circular shape and is directed upwardly with the nozzle device 100 having the one posture. The lower surface 120 has a circular shape and is directed downwardly with the nozzle device 100 having the one posture. The center portion of the lower surface 120 is recessed in a mortar shape. The outer peripheral surface 130 is a cylindrical surface connecting the outer edge of the upper surface 110 to the outer edge of the lower surface 120.

In the nozzle body 101, two through holes 102, 103 are formed so as to extend in the upward-and-downward direction along the axial center of the nozzle body 101 and be close to each other. A replacement liquid pipe 61 forming part of the replacement liquid supply system 60 of Fig. 1 is inserted into the one through hole 102. A first gas pipe 71 forming part of the first gas supply system 70 of Fig. 1 is inserted into the other through hole 103.

As shown in Fig. 5, with the replacement liquid pipe 61 being inserted into the through hole 102, the tip portion of the replacement liquid pipe 61 is located in the lower end portion of the nozzle device 100 and functions as a replacement liquid discharge port 62 that downwardly discharges the replacement liquid. On the other hand, with the first gas pipe 71 being inserted into the through hole 103, the tip portion of the first gas pipe 71 is located in the lower end portion of the nozzle device 100 and functions as a first gas injection port 72 that downwardly injects the first gas. In Figs. 3 and 5, a flow of the replacement liquid discharged from the nozzle device 100 through the replacement liquid pipe 61 is indicated by the thick solid arrows. Further, a flow of the first gas injected from the nozzle device 100 through the first gas pipe 71 is indicated by the thick dotted arrows.

As shown in Fig. 3, in the vicinity of the lower end portion of the outer peripheral surface 130 of the nozzle body 101, a second gas injection port 131 and a third gas injection port 132 extending in a circumferential direction are formed in an annular shape over the entire circumference of the outer peripheral surface 130. The third gas injection port 132 is located above the second gas injection port 131 and is close to the second gas injection port 131. In Fig. 3, the dotted pattern is applied to the second gas injection port 131 and the third gas injection port 132 in order to facilitate understanding of the shapes.

A second gas pipe 81 forming part of the second gas supply system 80 of Fig. 1 and a third gas pipe 91 forming part of the third gas supply system 90 of Fig. 1 are connected to the outer peripheral surface of the nozzle body 101.

As shown in Fig. 5, in the nozzle body 101, a gas flow path 141 guiding the second gas supplied from the second gas pipe 81 to the second gas injection port 131 is formed. Further, in the nozzle body 101, a gas flow path 142 guiding the third gas supplied from the third gas pipe 91 to the third gas injection port 132 is formed.

Thus, as indicated by the thick one-dot and dash arrows in each of Figs. 3 to 5, in a case in which the second gas is supplied to the nozzle device 100, the second gas is injected from the second gas injection port 131 through the second gas pipe 81 and the gas flow path 141. A flow of the second gas injected from the second gas injection port 131 spreads radially in the direction orthogonal to the axial center of the nozzle body 101.

Thus, as indicated by the thick two-dot and dash arrows in each of Figs. 3 to 5, in a case in which the third gas is supplied to the nozzle device 100, the third gas is injected from the third gas injection port 132 through the third gas pipe 91 and the gas flow path 142. Similarly to a flow of the second gas, a flow of the third gas injected from the third gas injection port 132 spreads radially in the direction orthogonal to the axial center of the nozzle body 101.

### 3. Control System of Substrate Processing Apparatus 1

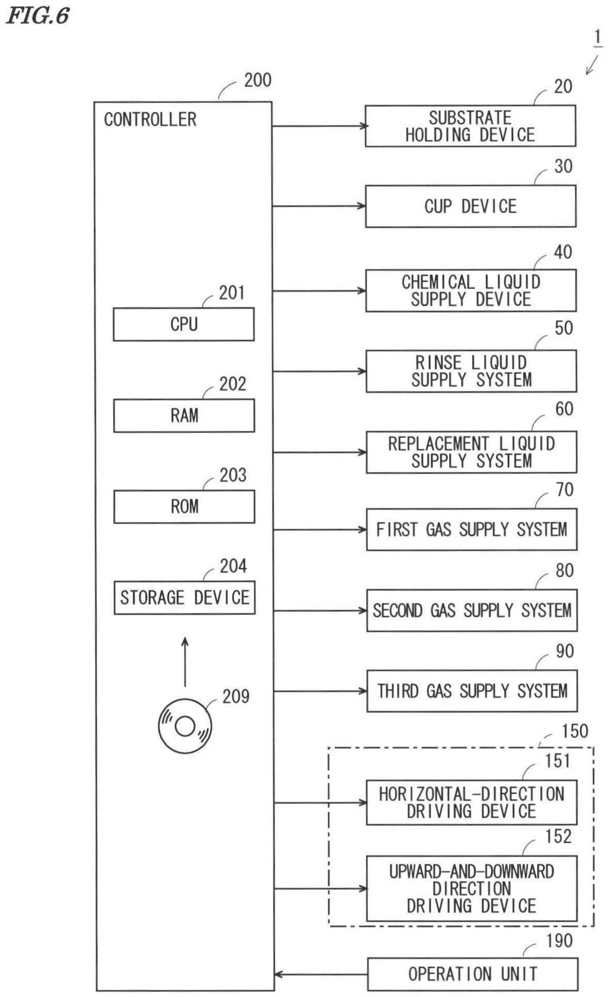

A control system of the substrate processing apparatus 1 will be described together with the configuration of the controller 200 of Fig. 1. Fig. 6 is a block diagram showing the outline of the configuration of the control system of the substrate processing apparatus 1 of Fig. 1. As shown in Fig. 6, the controller 200 includes a Central Processing Unit (CPU) 201, a Random Access Memory (RAM) 202, a Read Only Memory (ROM) 203 and a storage device 204. The RAM 202 is used as a work area for the CPU 201. A system program is stored in the ROM 203. The storage device 204 includes a storage medium such as a hard disc or a semiconductor memory, and stores a substrate cleaning program, a liquid processing condition and a gas processing condition for executing a series of above-mentioned processes (the chemical liquid process, the rinsing process and the drying process) on the substrate W.

The substrate cleaning program may be provided while being stored in a recording medium such as a CD-ROM 209 and installed in the ROM 203 or the storage device 204. Alternatively, the substrate cleaning program may be distributed from a server outside of the substrate processing apparatus 1 via a communication network and installed in the ROM 203 or the storage device 204.

The CPU 201 executes the substrate cleaning program, thereby controlling the work of each component of the substrate processing apparatus 1. Specifically, the controller 200 controls the substrate holding device 20. Thus, the controller 200 causes the substrate holding device 20 to hold the substrate W carried into the substrate processing apparatus 1. Further, the controller 200 releases the holding state of the substrate W held by the substrate holding device 20 in order to carry the substrate W out of the substrate processing apparatus 1. Further, the controller 200 rotates the substrate W held by the substrate holding device 20 at a preset speed.

Further, the controller 200 controls the cup device 30. Thus, the controller 200 moves each of the outer cup 30A and the inner cup 30B of Fig. 1 between the cup upper position and the cup lower position.

Further, the controller 200 controls the chemical liquid supply device 40. Thus, during the chemical liquid process, the controller 200 moves the chemical liquid nozzle 41 in the chamber CH and supplies the chemical liquid to the chemical liquid nozzle 41. Further, the controller 200 controls the rinse liquid supply system 50. Thus, during the rinsing process, the controller 200 supplies the rinse liquid to the rinse liquid nozzle 51.

Further, the controller 200 controls the replacement liquid supply system 60. Thus, in a case in which the rinse liquid on the substrate W is replaced with the replacement liquid in the drying process, the controller 200 supplies the replacement liquid to the nozzle device 100.

Further, the controller 200 controls the first gas supply system 70, the second gas supply system 80 and the third gas supply system 90. Thus, in a case in which the replacement liquid on the substrate W is removed in the drying process, the controller 200 supplies the first gas to the nozzle device 100. Further, during the drying process, the controller 200 supplies the second gas and the third gas to the nozzle device 100.

Further, the controller 200 controls the horizontal-direction driving device 151 and the upward-and-downward direction driving device 152 of the nozzle movement device 150. Thus, during the drying process, the controller 200 moves the nozzle device 100 in the chamber CH.

A liquid processing condition stored in the storage device 204 includes a liquid flow-rate condition and a liquid movement condition. A liquid flow-rate condition and a liquid movement condition will be described below. Further, a gas processing condition stored in the storage device 204 includes a gas flow-rate condition and a gas movement condition. A gas flow-rate condition and a gas movement condition will be described below.

The substrate processing apparatus 1 further includes an operation unit 190. The operation unit 190 includes a keyboard and a pointing device, for example, and is configured to be operable by a user. The user can input the liquid processing condition and the gas processing condition, described above, by operating the operation unit 190. The input liquid processing condition and the input gas processing condition are stored in the storage device 204 of the controller 200.

### 4. Details and Specific Example of Liquid Processing Condition

In the substrate processing apparatus 1 according to the present embodiment, a plurality of divided areas for respectively identifying a plurality of portions are defined in the plurality of portions of the upper surface of the substrate W (the plurality of portions of the upper surface of the substrate W in plan view) held by the substrate holding device 20.

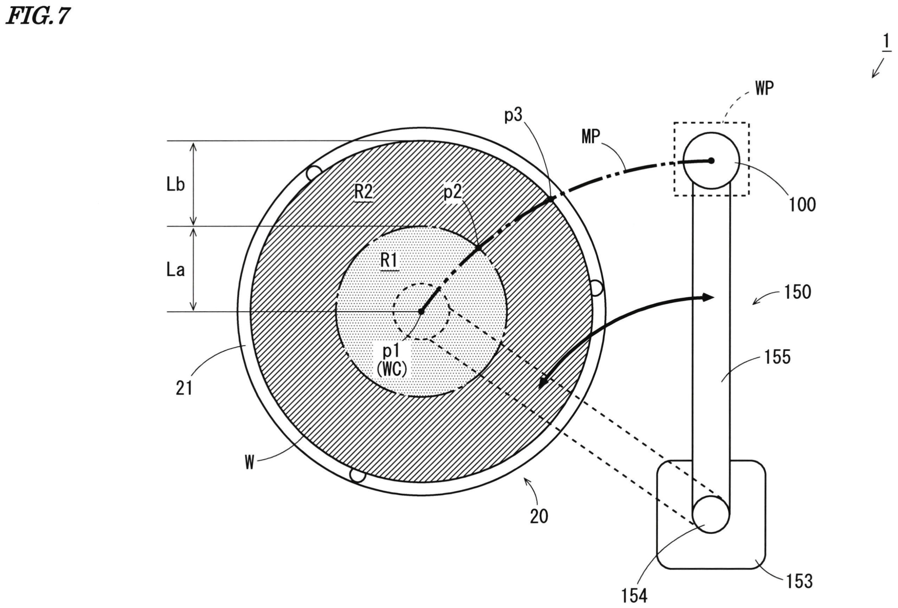

Fig. 7 is a plan view showing one example of the plurality of divided areas defined on the upper surface of the substrate W to be processed. In Fig. 7, the substrate holding device 20 and the nozzle movement device 150 of Fig. 1 are shown together with the substrate W.

In the example of Fig. 7, a divided area R1 is defined in the center portion of the upper surface of the substrate W, and a divided area R2 is defined outside of the center portion of the upper surface of the substrate W. The divided area R1 has a circular shape with reference to the center WC of the substrate W. A length La of the radius of the divided area R1 is 1/2 of the radius of the substrate W. The divided area R2 includes the outer peripheral end of the substrate W and has an annular shape surrounding the divided area R1. Further, the divided area R2 is adjacent to the divided area R1. A length Lb between the inner circumference and the outer circumference of the divided area R2, that is, the width of the divided area R2 in the radial direction of the substrate W is equal to the length La of the divided area R1.

In Fig. 7, the dotted pattern is applied to the divided area R1 and the hatching is applied to the divided area R2 in order to facilitate understanding of the shapes of the divided areas R1, R2 defined on the substrate W.

During the drying process, the nozzle movement device 150 moves the nozzle device 100 from the waiting position WP sideward of the substrate W to a space above the substrate W as described above. Further, the nozzle movement device 150 moves the nozzle device 100 from the space above the substrate W to the waiting position WP.

In Fig. 7, a movement path MP of the nozzle device 100 during the drying process in the horizontal direction is indicated by the thick two-dot and dash line. The movement path MP extends in an arc shape. One end portion of the movement path MP overlaps with the center WC of the substrate W in plan view, and the other end portion of the movement path MP overlaps with the waiting position WP in plan view.

In the following description, as indicated by the three black dots in Fig. 7, three positions on the movement path MP are referred to as a first position p1, a second position p2 and a third position p3. The first position p1 overlaps with the center WC of the substrate W and is located at one end of the movement path MP in plan view. The second position p2 is on the movement path MP and overlaps with the boundary between the divided areas R1, R2 in plan view. The third position p3 is on the movement path MP and overlaps with the outer peripheral end of the substrate W in plan view.

In a case in which the rinse liquid on the substrate W is replaced with the replacement liquid in the drying process, the nozzle device 100 moves on the movement path MP from the first position p1 toward the third position p3 in plan view while downwardly discharging the replacement liquid. In this case, the nozzle device 100 is opposite to the divided area R1 of the substrate W at a position above the substrate W while moving from the first position p1 to the second position p2 on the movement path MP. Further, the nozzle device 100 is opposite to the divided area R2 of the substrate W at a position above the substrate W while moving from the second position p2 to the third position p3 on the movement path MP.

Here, a liquid flow-rate condition defines a flow rate of the replacement liquid to be supplied to each of the plurality of portions (divided areas R1, R2) of the substrate W (an amount of the replacement liquid to be supplied per unit time). More specifically, a liquid flow-rate condition of the present example defines a flow rate of the replacement liquid to be supplied to the nozzle device 100 with the nozzle device 100 being opposite to each portion of the substrate W in a case in which the nozzle device 100 moves along the movement path MP.

Further, a liquid movement condition defines a movement speed of the nozzle device 100 when the nozzle device 100 moves in the space above each portion of the substrate W in order to supply the replacement liquid to each of the plurality of portions (the divided areas R1, R2) of the substrate W. More specifically, a liquid movement condition of the present example defines a movement speed of the nozzle device 100 in the horizontal direction when the nozzle device 100 is opposite to each portion of the substrate W when the replacement liquid is supplied to the substrate W.

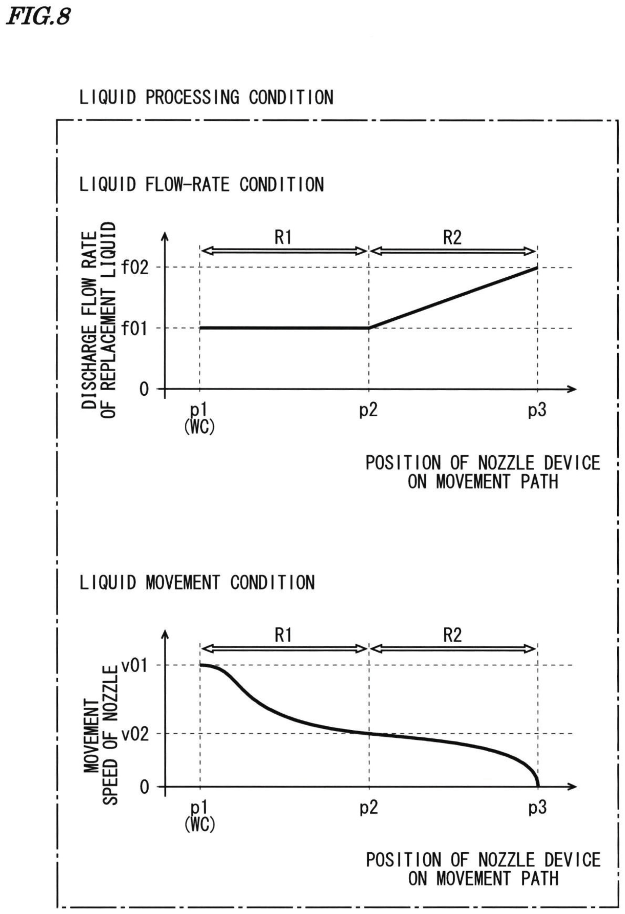

Fig. 8 is a diagram showing one example of a liquid processing condition. In the upper field of Fig. 8, a liquid flow-rate condition of the liquid processing condition is shown by the graph. In the upper graph of Fig. 8, the ordinate indicates a discharge flow rate of the replacement liquid discharged from the nozzle device 100, and the abscissa indicates a position on the movement path MP of Fig. 7.

According to the liquid flow-rate condition of Fig. 8, the discharge flow rate of the replacement liquid when the nozzle device 100 is at a position opposite to the divided area R1 of the substrate W is defined to be constant at a flow rate f01. On the other hand, the discharge flow rate of the replacement liquid when the nozzle device 100 is at a position opposite to the divided area R2 of the substrate W is defined to increase at a constant rate as the nozzle device 100 approaches the third position p3 from the second position p2. Thus, the discharge flow rate of the replacement liquid when the nozzle device 100 is located at the third position p3 is a flow rate f02 larger than the discharge flow rate (flow rate f01) of the replacement liquid when the nozzle device 100 is located at the second position p2. In regard to the liquid flow-rate condition of the present example, the flow rate f01 is 200 (ml/min), for example, and the flow rate f02 is 500 (ml/min), for example.

In the lower field of Fig. 8, a liquid movement condition of the liquid processing condition is shown by the graph. In the lower graph of Fig. 8, the ordinate indicates a movement speed of the nozzle device 100, and the abscissa indicates a position on the movement path MP of Fig. 7.

According to the liquid movement condition of Fig. 8, the movement speed of the nozzle device 100 at a position opposite to the divided area R1 is defined to decrease as the nozzle device 100 approaches the second position p2 from the first position p1. In more detail, the movement speed of the nozzle device 100 is defined to be a highest speed v01 at the first position p1, and is defined to be a speed v02 lower than the speed v01 at the second position p2. Further, the movement speed of the nozzle device 100 gradually changes in a certain range from the first position p1 and gradually changes in a certain range from the second position p2, and relatively steeply changes in other portions.

Further, the movement speed of the nozzle device 100 when the nozzle device 100 is at a position opposite to the divided area R2 is defined to decrease as the nozzle device 100 approaches the third position p3 from the second position p2. In more detail, the movement speed of the nozzle device 100 is defined to be the speed v02 at the second position p2, and is defined to be 0 at the third position p3. Further, the movement speed of the nozzle device 100 is defined to gradually change from the second position p2 to a substantially intermediate position between the second position p2 and the third position p3, and steeply change in the vicinity of the third position p3.

Here, suppose that the nozzle device 100 moves at a constant speed from the first position p1 to the third position p3 along the movement path MP in the space above the rotating substrate W. In this case, the closer the nozzle device 100 is to the first position p1, that is, the center WC of the substrate, the smaller the area on the substrate W opposite to the nozzle device 100 per unit time. Further, the closer the nozzle device 100 is to the third position p3, that is, the outer peripheral end of the substrate W, the larger the area on the substrate W opposite to the nozzle device 100 per unit time. Therefore, in a case in which a fluid is supplied from the nozzle device 100 to the substrate W at a constant flow rate during the above-mentioned movement of the nozzle device 100, the closer an area to the center WC of the substrate W, the larger an amount of fluid to be supplied per unit time. Further, the closer an area to the outer peripheral end of the substrate W, the smaller an amount of fluid to be supplied per unit time. Therefore, efficiency of processing the substrate W by the fluid is degraded in the vicinity of the outer peripheral end of the substrate W as compared with the area of the center WC of the substrate W and its vicinity.

In regard to such a problem, according to the liquid processing condition of Fig. 8, in a case in which the rinse liquid on the substrate W is replaced with the replacement liquid in the drying process, an amount of the replacement liquid to be discharged from the nozzle device 100 and a movement speed of the nozzle device 100 are adjusted. Thus suppresses an excessive increase in amount of the replacement liquid supplied to the center WC of the substrate W and its vicinity per unit time. Further, an amount of the replacement liquid supplied to the outer peripheral end of the substrate W and its vicinity per unit time increases, and the efficiency of replacing the rinse liquid with the replacement liquid is improved in the outer peripheral end of the substrate W and its vicinity.

### 5. Details and Specific Example of Gas Processing Condition

In a case in which the replacement liquid on the substrate W is removed in the drying process, the nozzle device 100 moves on the movement path MP from the first position p1 toward the third position p3 in plan view while downwardly injecting the first gas. In this case, the nozzle device 100 is sequentially located opposite to the divided areas R1, R2 of the substrate W.

Here, a gas flow-rate condition defines a flow rate of the first gas to be supplied (injected) to each of the plurality of portions (the divided areas R1, R2) of the substrate W (an amount of the first gas to be supplied per unit time). More specifically, the gas flow-rate condition of the present example defines a flow rate of the first gas to be supplied to the nozzle device 100 with the nozzle device 100 being opposite to each portion of the substrate W in a case in which the nozzle device 100 moves along the movement path MP.

Further, a gas movement condition defines a movement speed of the nozzle device 100 when the nozzle device 100 moves in the space above each portion of the substrate W in order to supply the first gas to each of the plurality of portions (the divided areas R1, R2) of the substrate W. More specifically, the gas movement condition of the present example defines a movement speed of the nozzle device 100 in the horizontal direction when the nozzle device 100 is opposite to each portion of the substrate W when the first gas is supplied to the substrate W.

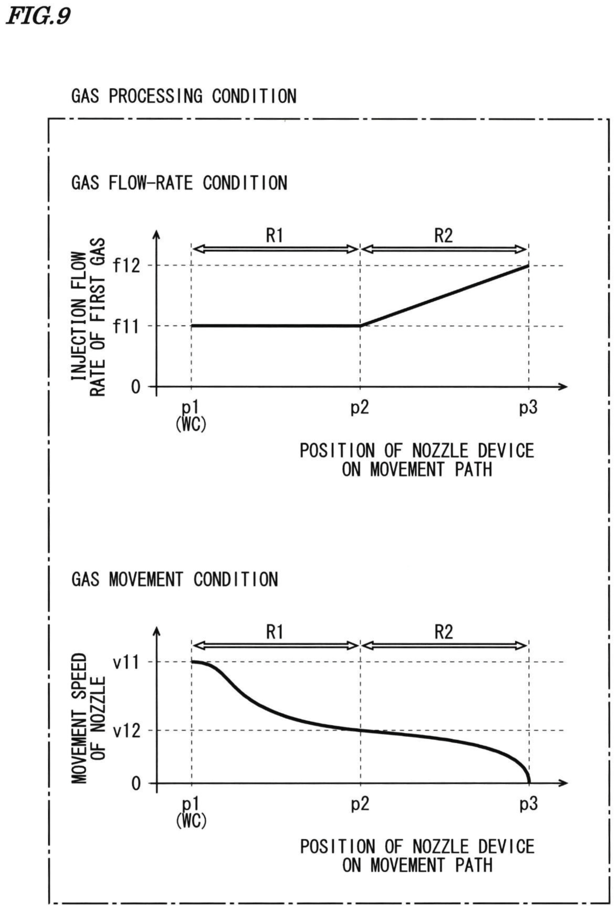

Fig. 9 is a diagram showing one example of a gas processing condition. In the upper field of Fig. 9, a gas flow-rate condition of the gas processing condition is shown by the graph. In the upper graph of Fig. 9, the ordinate indicates an injection flow rate of the first gas injected from the nozzle device 100, and the abscissa indicates a position on the movement path MP of Fig. 7.

According to the gas flow-rate condition of Fig. 9, the injection flow rate of the first gas when the nozzle device 100 is located at a position opposite to the divided area R1 of the substrate W is defined to be constant at a flow rate f11. On the other hand, the injection flow rate of the first gas when the nozzle device 100 is located at a position opposite to the divided area R2 of the substrate W is defined to increase at a constant rate as the nozzle device 100 approaches the third position p3 from the second position p2. Thus, the injection flow rate of the first gas when the nozzle device 100 is located at the third position p3 is a flow rate f12 larger than the injection flow rate (flow rate f11) of the first gas when the nozzle device 100 is located at the second position p2. In regard to the gas flow-rate condition of the present example, the flow rate f11 is 50 (ml/min), for example, and the flow rate f12 is 100 (ml/min), for example.

In the lower field of Fig. 9, a gas movement condition of the gas processing condition is shown by the graph. In the upper graph of Fig. 9, the ordinate indicates a movement speed of the nozzle device 100, and the abscissa indicates a position on the movement path MP of Fig. 7.

According to the gas movement condition of Fig. 9, the movement speed of the nozzle device 100 at a position opposite to the divided area R1 is defined to decrease as the nozzle device 100 approaches the second position p2 from the first position p1 similarly to the example of the liquid movement condition of Fig. 8. In more detail, the movement speed of the nozzle device 100 is defined to be a highest speed v11 at the first position p1, and is defined to be a speed v12 lower than the speed v11 at the second position p2. Further, the movement speed of the nozzle device 100 gradually changes in a certain range from the first position p1 and gradually changes in a certain range from the second position p2, and relatively steeply changes in other portions.

Further, the movement speed of the nozzle device 100 when the nozzle device 100 is at a position opposite to the divided area R2 is defined to decrease as the nozzle device 100 approaches the third position p3 from the second position p2 similarly to the example of the liquid movement condition of Fig. 8. In more detail, the movement speed of the nozzle device 100 is defined to be the speed v12 at the second position p2, and is defined to be 0 at the third position p3. Further, the movement speed of the nozzle device 100 is defined to gradually change from the second position p2 to a substantially intermediate position between the second position p2 and the third position p3, and steeply change in the vicinity of the third position p3.

In this manner, according to the gas processing condition of Fig. 9, in a case in which the replacement liquid on the substrate W is removed in the drying process, an amount of the first gas injected from the nozzle device 100 and a movement speed of the nozzle device 100 are adjusted. This suppresses an excessive increase of an amount of the first gas supplied to the center WC of the substrate W and its vicinity per unit time. Further, an amount of the first gas supplied to the outer peripheral end of the substrate W and its vicinity per unit time increases, and the efficiency of removing the replacement liquid using the first gas is improved in the outer peripheral end of the substrate W and its vicinity.

### 6. Functions for Control Based on Liquid Processing Condition and Gas Processing Condition

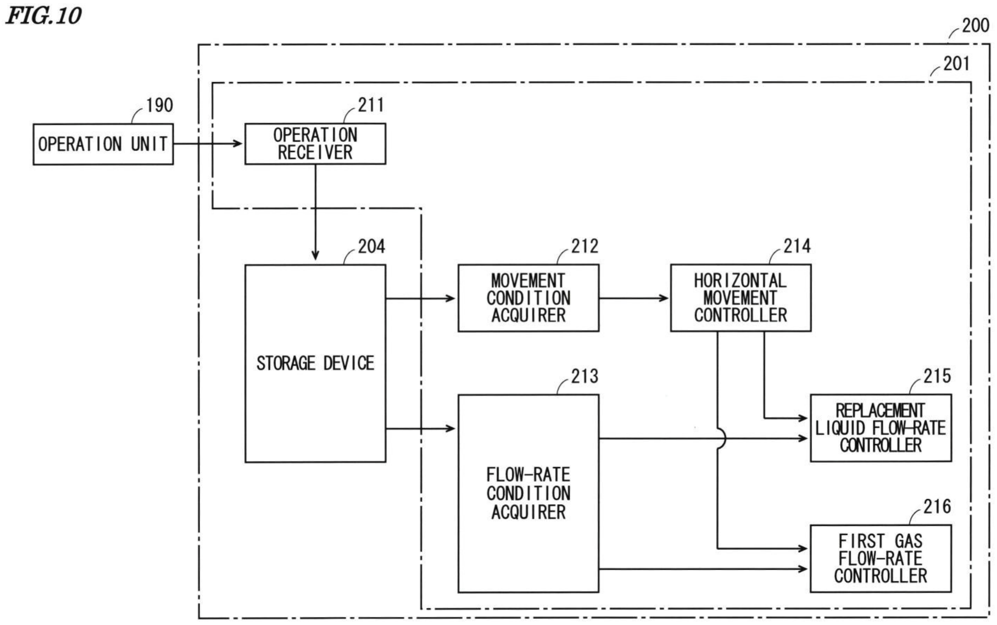

Fig. 10 is a block diagram for explaining one example configuration of the functions for control based on a liquid processing condition and a gas processing condition. As shown in Fig. 10, the CPU 201 of the controller 200 includes an operation receiver 211, a movement condition acquirer 212, a flow-rate condition acquirer 213, a horizontal movement controller 214, a replacement liquid flow-rate controller 215 and a first gas flow-rate controller 216 as functions for control based on a liquid processing condition and a gas processing condition. These functions are implemented by execution by the CPU of the controller 200 of the substrate cleaning program stored in the storage device 204. Part or all of the above-mentioned functions may be realized by hardware such as an electronic circuit.

The operation receiver 211 receives a liquid processing condition and a gas processing condition from the operation unit 190 of Fig. 6. Further, the operation receiver 211 stores the received liquid processing condition and the received gas processing condition in the storage device 204.

In a case in which the drying process is executed on the substrate W, the movement condition acquirer 212 acquires a liquid movement condition of the liquid processing condition stored in the storage device 204. Further, the movement condition acquirer 212 acquires a gas movement condition of the gas processing condition stored in the storage device 204. Further, the movement condition acquirer 212 provides the acquired liquid movement condition and the acquired gas movement condition to the horizontal movement controller 214.

In a case in which the drying process is executed on the substrate W, the flow-rate condition acquirer 213 acquires a liquid flow-rate condition of the liquid processing condition stored in the storage device 204. Further, the flow-rate condition acquirer 213 acquires a gas flow-rate condition of the gas processing condition stored in the storage device 204. Further, the flow-rate condition acquirer 213 provides the acquired liquid flow-rate condition to the replacement liquid flow-rate controller 215, and provides the acquired gas flow-rate condition to the first gas flow-rate controller 216.

When the drying process for the substrate W is started, the horizontal movement controller 214 controls the horizontal-direction driving device 151 of Fig. 6 based on the liquid movement condition provided from the movement condition acquirer 212. The horizontal-direction driving device 151 according to the present embodiment includes a pulse motor as a driving source. In this case, the horizontal movement controller 214 controls a rotation angle of the pulse motor by providing one or a plurality of drive pulses to the horizontal-direction driving device 151. At this time, the horizontal movement controller 214 detects a rotation angle of the pulse motor by counting the number of drive pulses provided to the horizontal-direction driving device 151.

Further, the horizontal movement controller 214 detects a position of the nozzle device 100 on the movement path MP based on the detected rotation angle of the pulse motor. That is, the horizontal movement controller 214 detects a relative position of the nozzle device 100 with respect to the substrate W in a horizontal plane.

The horizontal-direction driving device 151 may include a motor having a built-in encoder. In this case, the horizontal movement controller 214 may detect a rotation angle of the motor based on an output signal of the encoder of the horizontal-direction driving device 151, and detect a position of the nozzle device 100 on the movement path MP.

Further, the horizontal movement controller 214 provides information representing a detected position of the nozzle device 100 on the movement path MP to the replacement liquid flow-rate controller 215 and the first gas flow-rate controller 216.

In a case in which the rinse liquid on the substrate W is replaced with the replacement liquid in the drying process for the substrate W, the replacement liquid flow-rate controller 215 controls the replacement liquid supply system 60 of Fig. 6 based on the liquid flow-rate condition and the information provided from the horizontal movement controller 214. Thus, depending on a position of the nozzle device 100 with respect to the substrate W, the replacement liquid is supplied to the nozzle device 100 at a flow rate according to the liquid flow-rate condition.

In a case in which the replacement liquid on the substrate W is removed in the drying process for the substrate W, the first gas flow-rate controller 216 controls the first gas supply system 70 of Fig. 6 based on the gas flow-rate condition and the information provided from the horizontal movement controller 214. Thus, depending on a position of the nozzle device 100 with respect to the substrate, the first gas is supplied to the nozzle device 100 at a flow rate according to the gas flow-rate condition.

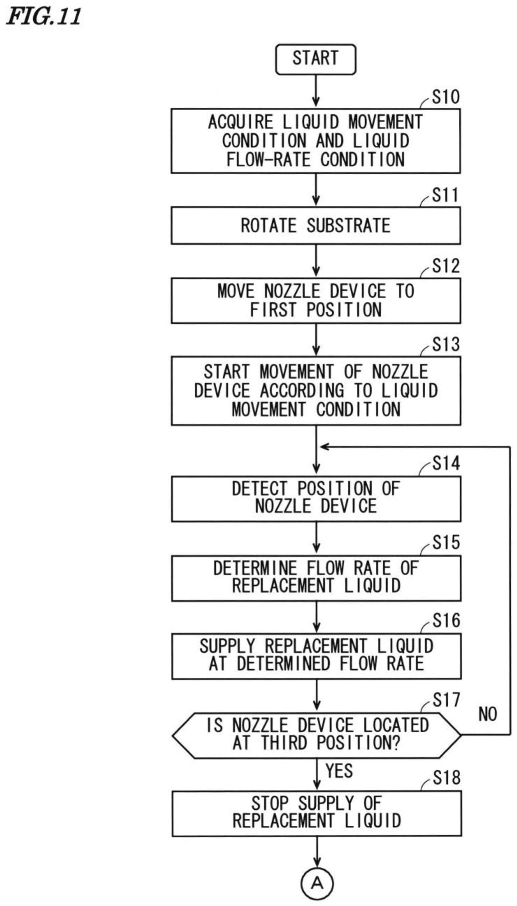

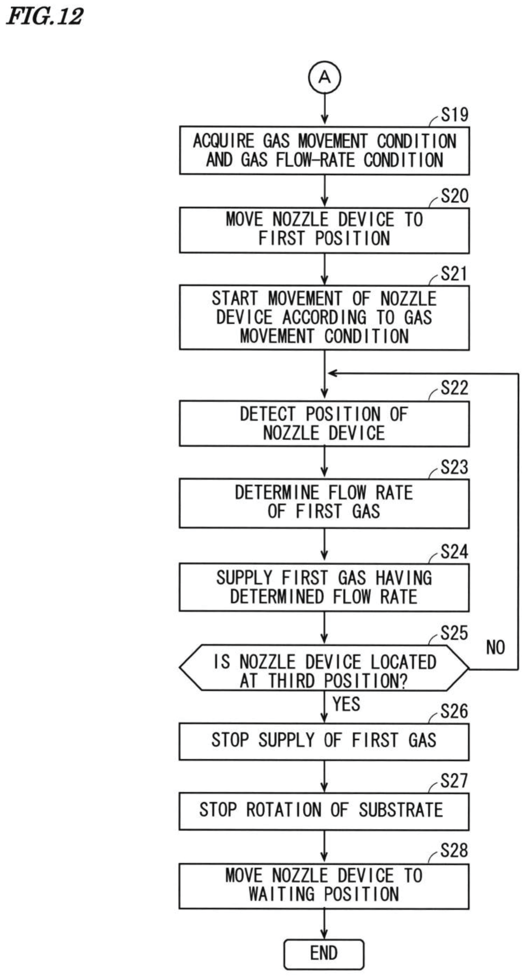

Figs. 11 and 12 are flowcharts showing a flow of process by the plurality of functions of Fig. 10. In Figs. 11 and 12, in order to show the process by the plurality of functions of Fig. 10, description of a process related to the movement of the nozzle device 100 in the upward-and-downward direction and a process of supplying the second gas and the third gas to the nozzle device 100 is not shown.

When the CPU 201 of Fig. 6 executes the substrate cleaning program, the drying process for the substrate W is started at a predetermined point in time. In an initial state, a liquid processing condition and a gas processing condition are stored in advance in the storage device 204 based on an operation of the operation unit 190 by the user.

When the drying process for the substrate W is started, the movement condition acquirer 212 and the flow-rate condition acquirer 213 acquire the liquid movement condition and the liquid flow-rate condition, respectively (step S10). Next, the controller 200 controls the rotation driver 22 of the substrate holding device 20 to rotate the substrate W at a predetermined speed (step S11).

Next, the horizontal movement controller 214 controls the horizontal-direction driving device 151 to move the nozzle device 100 to the first position p1 (step S12). When the nozzle device 100 reaches the first position p1, the horizontal movement controller 214 starts the movement of the nozzle device 100 according to the acquired liquid movement condition (step S13).

Subsequently, the horizontal movement controller 214 counts the number of drive pulses provided to the horizontal-direction driving device 151 to detect a position of the nozzle device 100 on the movement path MP based on the counted number of drive pulses (step S14).

Next, the replacement liquid flow-rate controller 215 determines a flow rate of the replacement liquid to be supplied to the nozzle device 100 at a current point in time based on the liquid flow-rate condition and the detected position of the nozzle device 100 (step S15).

Next, the replacement liquid flow-rate controller 215 controls the replacement liquid supply system 60 to supply the replacement liquid to the nozzle device 100 at a determined flow rate (step S16). Thereafter, the horizontal movement controller 214 determines whether the nozzle device 100 is located at the third position p3 (step S17).

In a case in which the nozzle device 100 is not located at the third position p3, the process returns to the step S14. On the other hand, in a case in which the nozzle device 100 is located at the third position p3, the replacement liquid flow-rate controller 215 stops the supply of the replacement liquid to the nozzle device 100 (step S18).

Next, the movement condition acquirer 212 and the flow-rate condition acquirer 213 acquire a gas movement condition and a gas flow-rate condition, respectively (step S19). Further, the horizontal movement controller 214 controls the horizontal-direction driving device 151 to move the nozzle device 100 to the first position p1 again (step S20). When the nozzle device 100 reaches the first position p1, the horizontal movement controller 214 starts the movement of the nozzle device 100 according to the acquired gas movement condition (step S21).

Next, the horizontal movement controller 214 detects a position of the nozzle device 100 on the movement path MP using the method similar to the method of the step S14 (step S22).

Next, the first gas flow-rate controller 216 determines a flow rate of the first gas to be supplied to the nozzle device 100 at a current point in time based on the gas flow-rate condition and the detected position of the nozzle device 100 (step S23).

Next, the first gas flow-rate controller 216 controls the first gas supply system 70 to supply the first gas to the nozzle device 100 at a determined flow rate (step S24). Thereafter, the horizontal movement controller 214 determines whether the nozzle device 100 is located at the third position p3 (step S25).

In a case in which the nozzle device 100 is not located at the third position p3, the process returns to the step S22. On the other hand, in a case in which the nozzle device 100 is located at the third position p3, the first gas flow-rate controller 216 stops the supply of the first gas to the nozzle device 100 (step S26).

Finally, the controller 200 controls the rotation driver 22 of the substrate holding device 20 to stop the rotation of the substrate W (step S27), and moves the nozzle device 100 to the waiting position WP (step S28). Thus, the drying process for the substrate W ends.

### 7. Work of Substrate Processing Apparatus 1

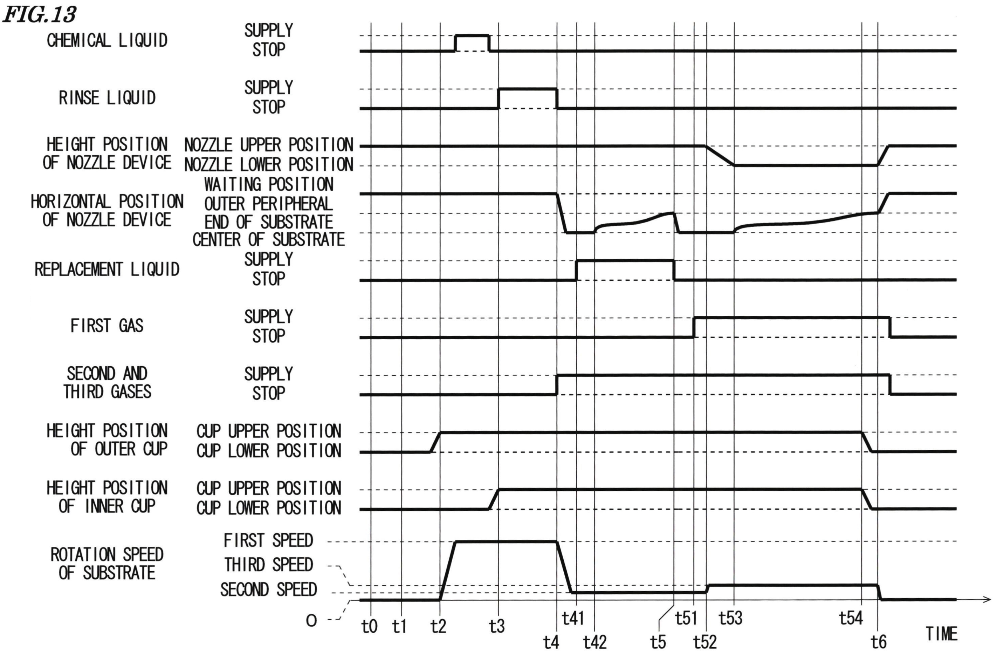

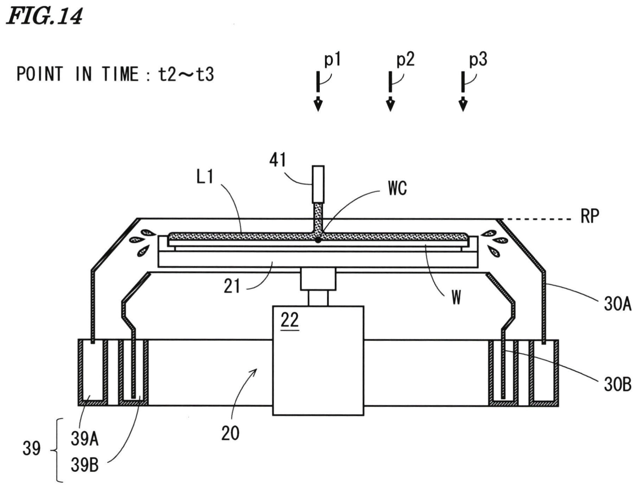

An example of specific work of the substrate processing apparatus 1 in a case in which a series of processes is executed on the substrate W by execution of the substrate cleaning program by the CPU 201 of Fig. 6 will be described. Fig. 13 is a time chart for explaining one example of the work of each constituent element in a case in which the series of processes is executed on the substrate using the substrate processing apparatus 1 of Fig. 1. Figs. 14 to 24 are schematic side views showing the work of each constituent element of the substrate processing apparatus 1 according to the time chart of Fig. 13. The diameter of the substrate W to be processed in the present example is 300 mm.

At the left end of Fig. 13, ten items subjected to control in regard to the work of the substrate processing apparatus 1 are shown. The ten items are "CHEMICAL LIQUID," "RINSE LIQUID," "HEIGHT POSITION OF NOZZLE," "HORIZONTAL POSITION OF NOZZLE," "REPLACEMENT LIQUID," "FIRST GAS," "SECOND AND THIRD GASES," "HEIGHT POSITION OF OUTER CUP," "HEIGHT POSITION OF INNER CUP" and "ROTATION SPEED OF SUBSTRATE," and are arranged in this order from the top position (first row) to the bottom position (tenth row) in an upward-and-downward direction.

At the right of the above-mentioned ten items, the control contents corresponding to these items are shown in a chronological order using the common time axis. At the right of the item "CHEMICAL LIQUID" in the first row, whether the chemical liquid is supplied from the chemical liquid supply device 40 to the chemical liquid nozzle 41 (supply or stop) is shown. At the right of the item "RINSE LIQUID" in the second row, whether the rinse liquid is supplied from the rinse liquid supply system 50 to the rinse liquid nozzle 51 (supply or stop) is shown.

At the right of the item "HEIGHT POSITION OF NOZZLE DEVICE" in the third row, positions (the nozzle upper position and the nozzle lower position) in the upward-and-downward direction of the nozzle device 100 in the substrate processing apparatus 1 are shown. At the right of the item "HORIZONTAL POSITION OF NOZZLE DEVICE" in the fourth row, a position of the nozzle device 100 in a horizontal plane in the substrate processing apparatus 1 is shown. A "WAITING POSITION" represented as a horizontal position is the waiting position WP in Fig. 7. Further, the "OUTER PERIPHERAL END OF SUBSTRATE" is the position of the nozzle device 100 (the third position p3 of Fig. 7) when the nozzle device 100 overlaps with the outer peripheral end of the substrate W in plan view, that is, when the nozzle device 100 is above the outer peripheral end of the substrate W. Further, the "CENTER OF SUBSTRATE" is the position of the nozzle device 100 (the first position p1 of Fig. 7) when the nozzle device 100 overlaps with the center WC of the substrate W in plan view, that is, when the nozzle device 100 is above the center WC of the substrate W.

At the right of the item "REPLACEMENT LIQUID" in the fifth row, whether the replacement liquid is supplied from the replacement liquid supply system 60 to the nozzle device 100 (supply or stop) is shown. At the right of the item "FIRST GAS" in the sixth row, whether the first gas is supplied from the first gas supply system 70 to the nozzle device 100 (supply or stop) is shown. At the right of the item "SECOND AND THIRD GASES" in the seventh row, whether the second gas and the third gas are supplied from the second gas supply system 80 and the third gas supply system 90 to the nozzle device 100 (supply or stop) is shown.

At the right of the item "HEIGHT POSITION OF OUTER CUP" in the eighth row, a position in the upward-and-downward direction of the outer cup 30A in the substrate processing apparatus 1 is shown. At the right of the item "HEIGHT POSITION OF INNER CUP" in the ninth row, a position in the upward-and-downward direction of the inner cup 30B in the substrate processing apparatus 1 is shown. At the right of the item "ROTATION SPEED OF SUBSTRATE" in the tenth row, a change in rotation speed of the rotating substrate W held by the substrate holding device 20 is shown.

In the schematic side views of Figs. 14 to 24, the first position p1, the second position p2 and the third position p3 on the movement path MP of Fig. 7 are indicated by the thick one-dot and dash arrows.

First, in an initial state (a point t0 in time), the supply of "CHEMICAL LIQUID" to the chemical liquid nozzle 41 is stopped. Further, the supply of "RINSE LIQUID" to the rinse liquid nozzle 51 is stopped. Further, the supply of "REPLACEMENT LIQUID," "FIRST GAS" and "SECOND AND THIRD GASES" to the nozzle device 100 is stopped. Further, the "HEIGHT POSITION OF NOZZLE" is kept at the nozzle upper position, the "HORIZONTAL POSITION OF NOZZLE" is kept at the waiting position, and the "HEIGHT POSITION OF OUTER CUP" and the "HEIGHT POSITION OF INNER CUP" are kept at the cup lower position. Further, in the initial state, because the substrate W is not held by the substrate holding device 20, the "ROTATION SPEED OF SUBSTRATE" is 0 rpm.

At a point t1 in time, the substrate W is carried into the chamber CH of the substrate processing apparatus 1, and the substrate W is placed on the substrate holder 21. Further, the substrate W is held by the substrate holder 21. Next, the chemical liquid process is executed on the substrate W from a point t2 to a point t3 in time. Specifically, the rotation of the substrate W held by the substrate holder 21 is started at the point t2 in time. Further, the rotation speed is increased from the 0 rpm to a first speed, which is relatively high, and is kept at the first speed. In the present embodiment, the first speed is 1500 rpm.

With the rotation speed of the substrate W kept at the first speed, the chemical liquid nozzle 41 is arranged at the processing position (the first position p1 in the present example) above the substrate W as shown in Fig. 14. Further, in a predetermined certain period, a chemical liquid L1 is discharged from the chemical liquid nozzle 41 toward the center WC of the substrate W. Thus, a liquid film of the chemical liquid L1 spreads over the entire upper surface of the substrate W.

As described above, the chemical liquid process proceeds. During the chemical liquid process, the chemical liquid L1 is splashed from the rotating substrate W. In order to receive the splashed chemical liquid L1, the outer cup 30A is set at the cup upper position immediately before the point t2 in time. Thus, the chemical liquid L1 received by the outer cup 30A is discarded through the outer container 39A. In Fig. 14, the height position of the upper end portion of the outer cup 30A located at the cup upper position is indicated by a reference character RP.

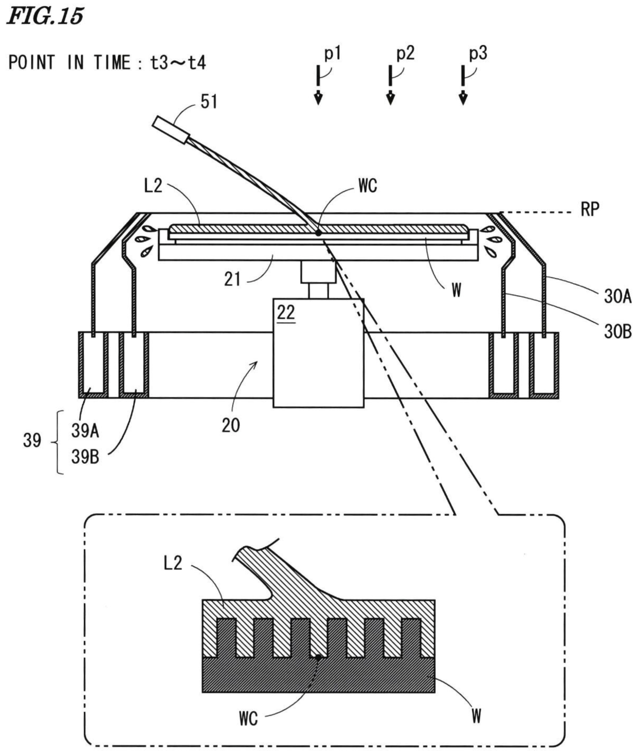

Next, after the discharge of the chemical liquid L1 from the chemical liquid nozzle 41 to the substrate W is stopped, the rinsing process is executed on the substrate W from the point t3 to a point t4 in time. In the rinsing process, the rotation speed of the substrate W is kept at the first speed. Further, as shown in Fig. 15, a rinse liquid L2 is discharged from the rinse liquid nozzle 51 toward the center WC of the substrate W. Thus, a liquid film of the rinse liquid L2 spreads over the entire upper surface of the substrate W, and the chemical liquid L1 remaining on the substrate W is replaced with the rinse liquid L2.

In Fig. 15, in the balloon of the two-dot and dash line, a partially enlarged cross-sectional view of the substrate W during the rinsing process is shown. With reference to this cross-sectional view, in the upper surface of the substrate W, multiple grooves having a depth in the direction orthogonal to the substrate W (the upward-and-downward direction in the present example) are formed to have a predetermined pattern. Each groove is filled with the rinse liquid L2.

As described above, the rinsing process proceeds. During the rinsing process, the rinse liquid L2 is mainly splashed from the rotating substrate W. In order to receive the splashed rinse liquid L2, the inner cup 30B is set at the cup upper position immediately before the point t3 in time. Thus, the rinse liquid L2 received by the inner cup 30B is discarded through the inner container 39B. **In** part of Fig. 15 and the subsequent diagrams, the height position of the upper end portion of the inner cup 30B located at the cup upper position is indicated by the reference character RP.

Next, after the rinsing process ends, the drying process for the substrate is executed from the point t4 to a point t6 in time. In the drying process, as a pre-process, a process of replacing the rinse liquid L2 remaining on the substrate W with the replacement liquid L3 is first executed from the point t4 to a point t5 in time. A point t41 and a point t42 in time, described below, indicate specific points in time between the point t4 and the point t5 in time.

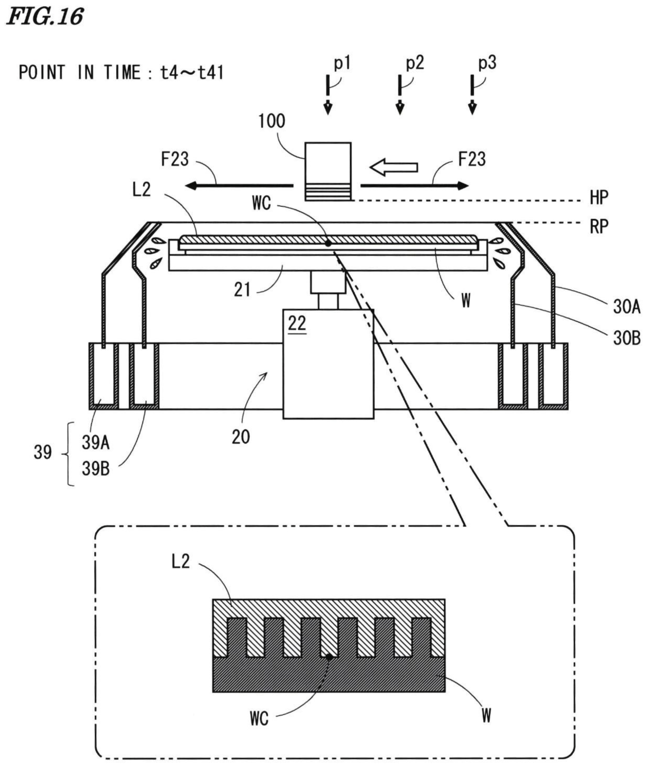

Specifically, as it passes the point t4 in time, with the height position of the nozzle device 100 kept at the nozzle upper position HP, the nozzle device 100 is moved in the horizontal direction from the waiting position WP to the first position p1 along the movement path MP of Fig. 7. This movement work corresponds to the work of the nozzle device 100 moved in the step S12 in Fig. 11. The nozzle upper position HP is the height position higher than the cup upper position of the outer cup 30A and the inner cup 30B. Thus, as shown in Fig. 16, the lower end portion of the nozzle device 100 (the replacement liquid discharge port 62 and the first gas injection port 72 of Fig. 5) is opposite to the center WC of the substrate W.

When it passes the point t4 in time, the second gas and the third gas are further supplied to the nozzle device 100 from the second gas supply system 80 and the third gas supply system 90. Thus, as indicated by the thick solid arrows in Fig. 16, a flow F23 of the second gas and the third gas is formed in the horizontal direction from the vicinity of the lower end portion of the nozzle device 100 (the second gas injection port 131 and the third gas injection port 132 of Fig. 5, specifically). **In** the present embodiment, the flow rate of the second gas supplied to the nozzle device 100 is 72.5 L/min, and the flow rate of the third gas supplied to the nozzle device 100 is also 72.5 L/min.

Further, when it passes the point t4 in time, the substrate holding device 20 is controlled, so that the rotation speed of the substrate W is reduced from the first speed to a second speed lower than the first speed and is kept at the second speed. In the present embodiment, the second speed is 100 rpm.

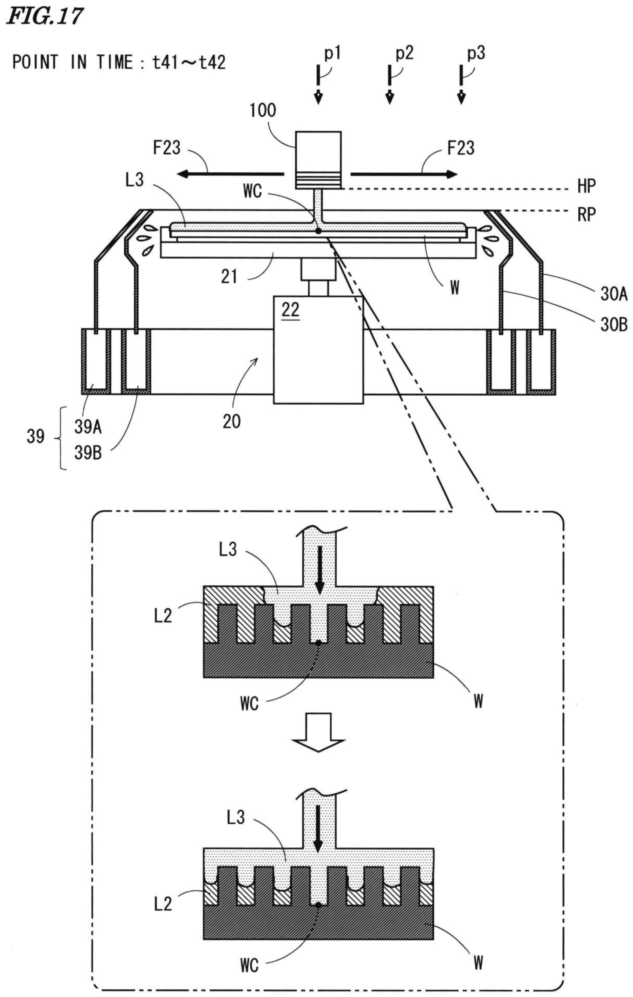

At the point t41 in time that is later than the point t4 in time by a minute period, the supply of the replacement liquid L3 from the replacement liquid supply system 60 to the nozzle device 100 is started. In this case, as shown in Fig. 17, the replacement liquid L3 is discharged from the lower end portion (the replacement liquid discharge port 62 of Fig. 5) of the nozzle device 100 toward the center WC of the substrate W. Thus, a liquid film of the replacement liquid L3 spreads over the entire upper surface of the substrate W. At this time, as shown in the upper portion in the balloon of the two-dot and dash line in Fig. 17, the replacement liquid L3 discharged in the direction orthogonal to the substrate W is smoothly guided into the plurality of grooves formed on the substrate W. Further, because being discharged from the nozzle device 100 located at the nozzle upper position HP, the replacement liquid L3 collides with the obverse surface of the substrate W with energy higher than the energy generated in a case in which the replacement liquid L3 is discharged from the nozzle device 100 located at the nozzle lower position. Thus, the rinse liquid L2 remaining in the grooves located at the center WC of the substrate W is more efficiently replaced with the replacement liquid L3.

However, in the area except for the center WC of the substrate W, since flowing in the horizontal direction toward the peripheral portion of the substrate W, the replacement liquid L3 is unlikely to enter each groove. Therefore, as shown in the lower portion in the balloon of the two-dot and dash line in Fig. 17, large part of the grooves is likely to have the rinse liquid L2. As such, in the present example, from the point t42 that is further later than the point t41 in time by a minute period to the point t5 in time, with the height position of the nozzle device 100 kept at the nozzle upper position HP, the nozzle device 100 is moved in the horizontal direction from the first position p1 to the third position p3. This movement work corresponds to the work of the nozzle device 100 that is started in the step S13 in Fig. 11. Thus, the movement speed of the nozzle device 100 is adjusted according to a position on the movement path MP.

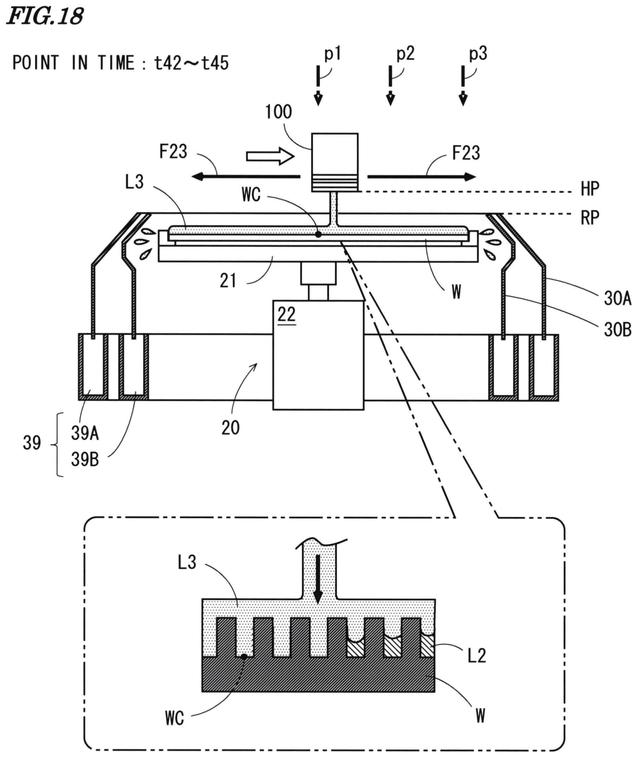

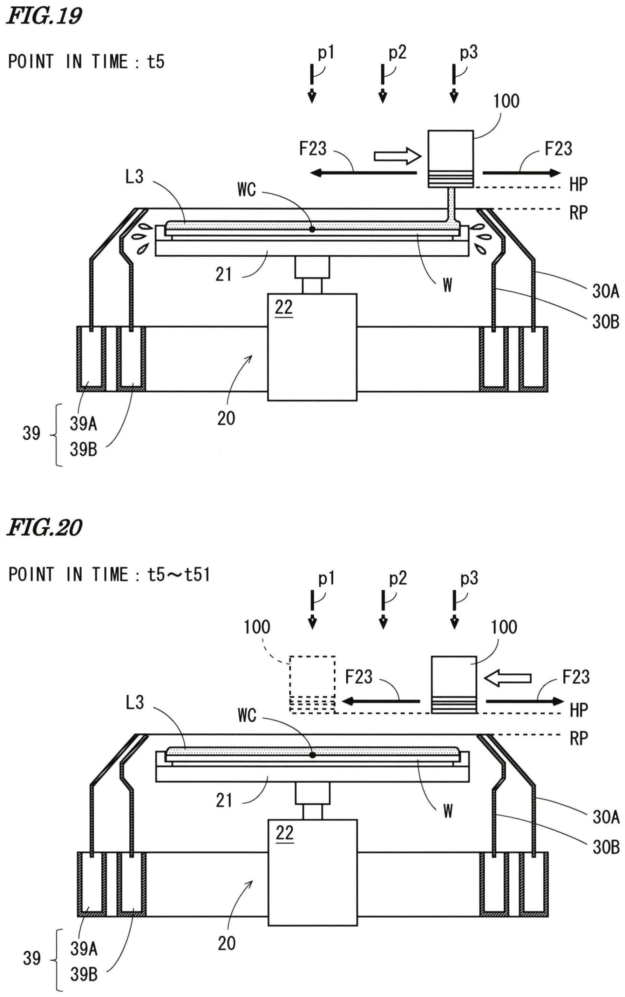

As shown in Fig. 18, in a case in which the nozzle device 100 moves on the movement path MP, as the nozzle device 100 is moved, the rinse liquid L2 in the grooves located immediately below the nozzle device 100 is forcibly replaced with the replacement liquid L3. Thereafter, as shown in Fig. 19, the nozzle device 100 reaches the outer peripheral end of the substrate at the point t5 in time, so that all of the grooves on the substrate W are filled with the replacement liquid L3, and the rinse liquid L2 is removed. The period of time from the point t42 to the point t5 in time is 5 sec, for example.

As described above, in the step of replacing the rinse liquid L2 on the substrate W with the replacement liquid L3, the nozzle device 100 is kept at the nozzle upper position HP. Further, as described above, the nozzle upper position HP is higher than the cup upper position of the outer cup 30A and the inner cup 30B. Thus, when the replacement liquid L3 is discharged to the outer peripheral end of the substrate W and its vicinity, the nozzle device 100 does not interfere with the outer cup 30A or the inner cup 30B.

The work for supplying the replacement liquid L3 to the nozzle device 100 from the point t42 to the point t5 in time corresponds to the process of the steps S14 to S17 in Fig. 11. Thus, the supply amount of the replacement liquid L3 to the nozzle device 100, that is the flow rate of the replacement liquid L3 discharged from the nozzle device 100 to the substrate W is adjusted according to a position on the movement path MP.

For example, the flow rate of the replacement liquid L3 discharged from the nozzle device 100 is kept at 200 (ml/min) in a period during which the nozzle device 100 moves from the first position p1 to the second position p2. Further, the flow rate of the replacement liquid L3 discharged from the nozzle device 100 is increased from 200 (ml/min) to 500 (ml/min) at a constant rate in a period during which the nozzle device 100 moves from the second position p2 to the third position p3.

Subsequently, as a post-process of the drying process, a process of removing the replacement liquid L3 remaining on the substrate W is executed from the point t5 to the point t6 in time. A point 51 in time, a point t52 in time, a point t53 in time and a point t54 in time, described below, indicate specific points in time between the points t5 and t6 in time.

Specifically, as it passes the point t5 in time, the supply of the replacement liquid L3 from the replacement liquid supply system 60 to the nozzle device 100 is stopped. Thereafter, as shown in Fig. 20, with the height position of the nozzle device 100 kept at the nozzle upper position HP, the nozzle device 100 is moved in the horizontal direction from the third position p3 to the first position p1 along the movement path MP of Fig. 7. This movement work corresponds to the work of the nozzle device 100 moved in the step S20 in Fig. 12.

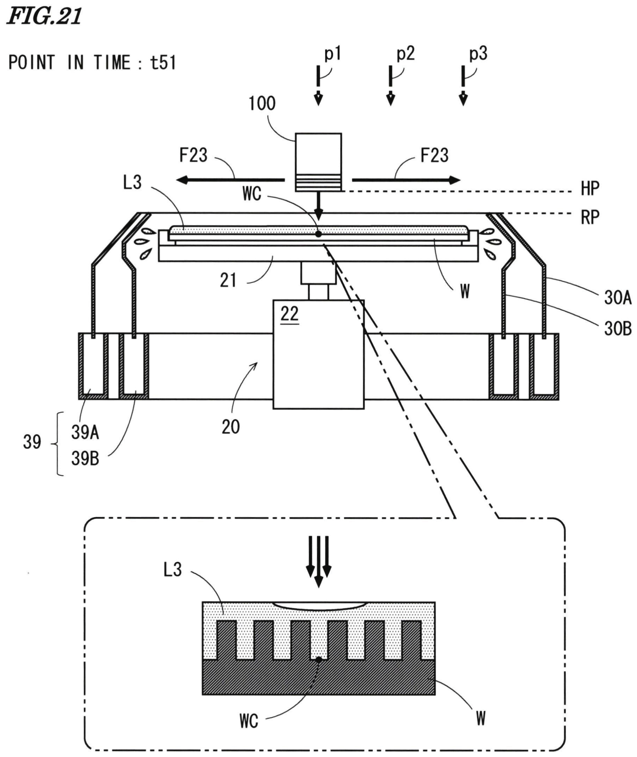

Next, at a point t51 in time that is later than the point t5 in time by a minute period, with the nozzle device 100 located above the center WC of the substrate W, the first gas is supplied from the first gas supply system 70 to the nozzle device 100. This supply work is performed between the step S20 and the step S21 in Fig. 12. Here, the flow rate of the first gas supplied to the nozzle device 100 is 5 L/min, 25 L/min or 50 L/min. **In** this case, as shown in Fig. 21, the first gas is injected from the lower end portion (the first gas injection port 72 of Fig. 5) of the nozzle device 100 toward the center WC of the substrate W.

At a point in time at which injection of the first gas is started, the nozzle device 100 is located at the nozzle upper position HP. Therefore, a relatively large distance is ensured between the nozzle device 100 and the substrate W. Therefore, a degree of impact generated when the first gas injected from the nozzle device 100 collides with the substrate W is sufficiently lower than the impact generated in a case in which the first gas is injected with the nozzle device 100 located at the nozzle lower position. Therefore, as shown in the balloon of the two-dot and dash line in Fig. 21, at the point t51 in time, the replacement liquid L3 on the substrate W is hardly affected by the first gas.

Next, at the point t52 in time, the rotation speed of the substrate W is increased from the second speed to a third speed that is higher than the second speed and lower than the first speed, and is kept at the third speed. **In** the present embodiment, the third speed is 300 rpm.

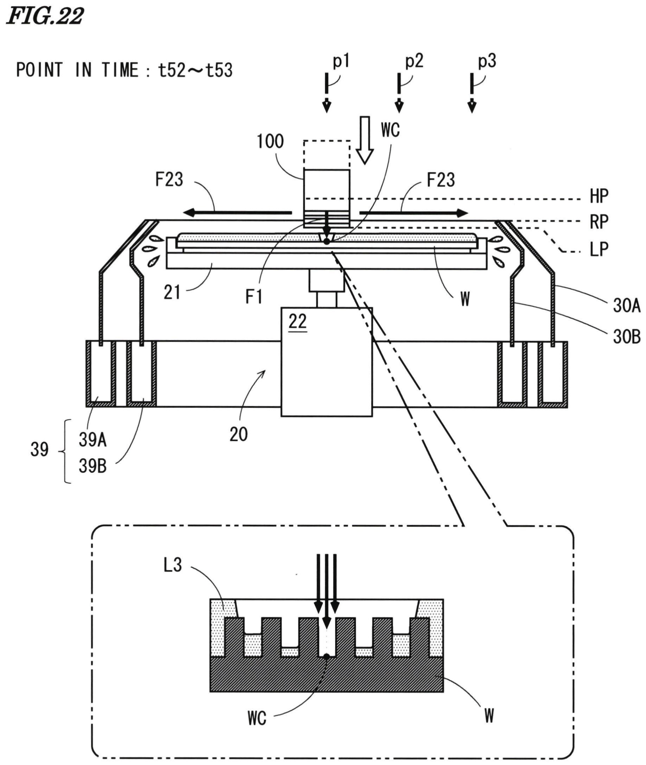

Further, from the point t52 to the point t53 in time, as shown in Fig. 22, the height position of the nozzle device 100 is lowered from the nozzle upper position HP to the nozzle lower position LP. The nozzle lower position LP is the height position lower than the nozzle upper position HP and higher than the substrate W. Thus, a degree of impact generated when the first gas injected from the nozzle device 100 collides with the substrate W gradually increases.

At this time, as shown in the balloon of the two-dot and dash line in Fig. 22, the first gas injected in the direction orthogonal to the substrate W is smoothly guided into the plurality of grooves in the pattern formed on the substrate W. Thus, the rinse liquid L2 remaining in the grooves located at the center WC of the substrate W is completely removed by the replacement liquid L3 at the point t53 in time.

However, in the area except for the center WC of the substrate W, since the first gas does not blow at the bottom portion of each groove, it is difficult to completely remove the replacement liquid L3 remaining in the groove. As such, in the present example, from the point t53 to the point t6 in time, with the height position of the nozzle device 100 kept at the nozzle lower position LP, the nozzle device 100 is moved in the horizontal direction from the center to the outer peripheral end of the substrate. This movement work corresponds to the work of the nozzle device 100 that is started in the step S21 in Fig. 12. Thus, the movement speed of the nozzle device 100 is adjusted according to a position on the movement path MP.

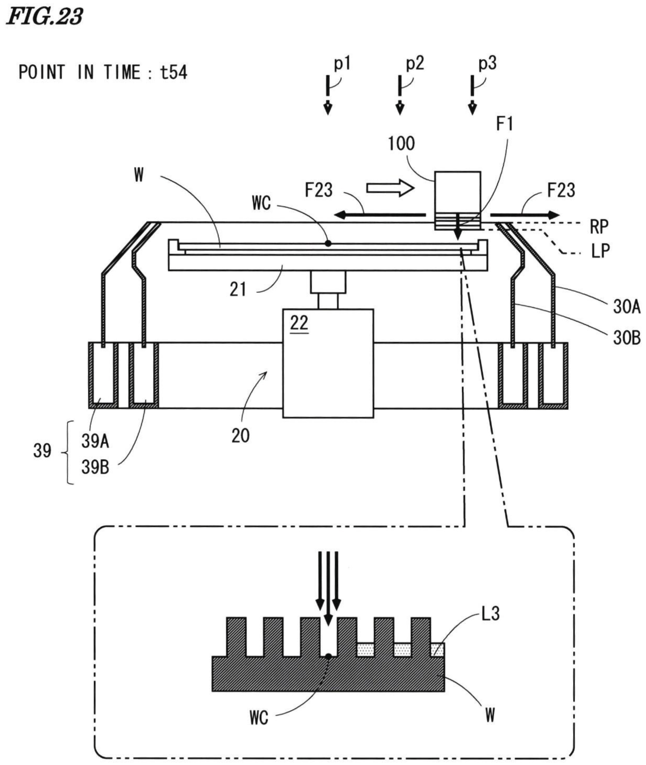

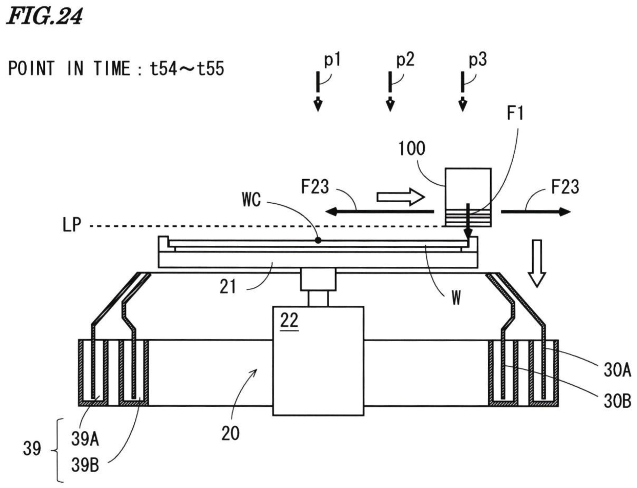

As shown in Fig. 23, in a case in which the nozzle device 100 moves on the movement path MP, as the nozzle device 100 moves, the replacement liquid L3 in the grooves located immediately below the nozzle device 100 is forcibly blown off and removed by the first gas. Thereafter, as shown in Fig. 24, the nozzle device 100 reaches the outer peripheral end of the substrate at the point t6 in time, so that the replacement liquid L3 in all of the grooves on the substrate W is completely removed, and the substrate W is dried. The period of time from the point t53 to the point t6 in time is 10 sec, for example.

Meanwhile, with the outer cup 30A and the inner cup 30B located at the cup upper position, when the nozzle device 100 located at the nozzle lower position LP moves toward the outer peripheral end of the substrate W, the nozzle device 100 is highly likely to interfere with the outer cup 30A and the inner cup 30B. As such, in the present example, at the point t54 in time immediately before the point t6 in time at which the nozzle device 100 reaches the outer peripheral end of the substrate, the height position of the outer cup 30A and the inner cup 30B is changed from the cup upper position to the cup lower position.

The work for supplying the first gas to the nozzle device 100 from the point t53 to the point t6 in time corresponds to the process of the steps S22 to S25 in Fig. 12. Thus, the supply amount of the first gas to the nozzle device 100, that is, the flow rate of the first gas injected from the nozzle device 100 to the substrate W is adjusted according to a position on the movement path MP.

For example, the flow rate of the first gas injected from the nozzle device 100 is kept at 50 (ml/min) in a period during which the nozzle device 100 moves from the first position p1 to the second position p2. Further, the flow rate of the first gas injected from the nozzle device 100 is increased from 50 (ml/min) to 100 (ml/min) at a constant rate in a period during which the nozzle device 100 moves from the second position p2 to the third position p3.

As described above, the drying process ends at the point t6 in time. After the drying process ends, the supply of the first gas, the second gas and the third gas to the nozzle device 100 is stopped. Further, the height position of the nozzle device 100 is adjusted to the nozzle upper position HP, and the nozzle device 100 is returned to the waiting position. Further, the rotation of the substrate W is stopped. In this state, the substrate W is carried out from the chamber CH of the substrate processing apparatus 1.

### 8. Effects of Embodiment

(a) With the above-mentioned substrate processing apparatus 1, the rinse liquid L2 remaining on the substrate W is replaced with the replacement liquid L3 in the pre-process of the drying process for the substrate W. At this time, an amount of the replacement liquid L3 supplied to each of a plurality of portions (divided areas R1, R2) of the substrate W is adjusted. Further, the movement speed of the nozzle device 100 when the nozzle device 100 moves to each of the plurality of portions (divided areas R1, R2) of the substrate W is adjusted. Thus, it is possible to appropriately replace the rinse liquid L2 remaining on the substrate W with the replacement liquid L3 depending on a portion of the substrate W. Therefore, it is possible to appropriately remove the rinse liquid L2 on the substrate W. Further, it is possible to reduce the consumption of the replacement liquid L3. As a result, it is possible to execute a process on the substrate W with high accuracy while suppressing the consumption of the replacement liquid L3 used for the process for the substrate W after pattern formation.

Specifically, as shown in the example of Fig. 8, suppose that, in regard to a liquid flow-rate condition, the flow rate of the replacement liquid L3 corresponding to the center WC of the substrate W and its vicinity is set low, and the flow rate of the replacement liquid L3 corresponding to the outer peripheral end of the substrate W and its vicinity is set high. In a case in which such a liquid flow-rate condition is used, it is possible to suppress supply of an excessive amount of the replacement liquid L3 to the center WC of the substrate W in the pre-process of the drying process for the substrate W. Further, a sufficient amount of the replacement liquid L3 for removing the rinse liquid L2 can be supplied to the outer peripheral end of the substrate W, and efficiency of replacing the rinse liquid L2 is improved.

Further, as shown in the example of Fig. 8, suppose that, in regard to a liquid movement condition, the movement speed corresponding to the center WC of the substrate W and the vicinity is set high, and the movement speed corresponding to the outer peripheral end of the substrate W and its vicinity is set low. In a case in which such a liquid movement condition is used, it is possible to suppress supply of an excessive amount of the replacement liquid L3 to the center WC of the substrate W in the pre-process of the drying process for the substrate W. Further, a sufficient amount of the replacement liquid L3 for removing the rinse liquid L2 can be supplied to the outer peripheral end of the substrate W, and efficiency of replacing the rinse liquid L2 is improved.

(b) With the above-mentioned substrate processing apparatus 1, the replacement liquid L3 remaining on the substrate W is removed by the first gas in the post-process of the drying process for the substrate W. At this time, an amount of the first gas supplied to each of the plurality of portions (divided areas R1, R2) of the substrate W is adjusted. Further, the movement speed of the nozzle device 100 when the nozzle device 100 moves to each of the plurality of portions (divided areas R1, R2) of the substrate W is adjusted. Thus, it is possible to appropriately blow off the replacement liquid L3 remaining on the substrate W using the first gas depending on a portion of the substrate W. Therefore, it is possible to appropriately remove the replacement liquid L3 on the substrate W. Further, it is possible to reduce the consumption of the first gas. As a result, it is possible to execute a process on the substrate W with high accuracy while suppressing the consumption of the first gas used for the process for the substrate W after pattern formation.

Specifically, as shown in the example of Fig. 9, suppose that, in regard to a gas flow-rate condition, the flow rate of the first gas corresponding to the center WC of the substrate W and its vicinity is set low, and the flow rate of the first gas corresponding to the outer peripheral end of the substrate W and its vicinity is set high. In a case in which such a gas flow-rate condition is used, it is possible to suppress supply of an excessive amount of the first gas to the center WC of the substrate W in the post-process of the drying process for the substrate W. Further, it is possible to supply a sufficient amount of the first gas to the outer peripheral end of the substrate W to remove the replacement liquid L3, and the efficiency of removing the replacement liquid L3 is improved.

Further, as shown in the example of Fig. 9, suppose that, in regard to a gas movement condition, the movement speed corresponding to the center WC of the substrate W and the vicinity is set high, and the movement speed corresponding to the outer peripheral end of the substrate W and its vicinity is set low. In a case in which such a gas movement condition is used, it is possible to suppress supply of an excessive amount of the first gas to the center WC of the substrate W in the post-process of the drying process for the substrate W. Further, it is possible to supply a sufficient amount of the first gas to the outer peripheral end of the substrate W to remove the replacement liquid L3, and the efficiency of removing the replacement liquid L3 is improved.

(c) In the above-mentioned substrate processing apparatus 1, in the pre-process of the drying process, the nozzle device 100 is arranged at the nozzle upper position HP, and the replacement liquid discharge port 62 is opposite to the center WC of the substrate W. In this state, the replacement liquid L3 is downwardly discharged from the replacement liquid discharge port 62 of the nozzle device 100. Further, the nozzle device 100 is moved in the horizontal direction from the center of the substrate to the outer peripheral end of the substrate. In this case, the nozzle device 100 is held at a height position spaced apart from the substrate W as compared with a case in which the nozzle device 100 is located at the nozzle lower position LP. In particular, the nozzle upper position HP is higher than the upper end portions of the outer cup 30A and the inner cup 30B that are located at the cup upper position. Therefore, when the nozzle device 100 moves toward the outer peripheral end of the substrate, the nozzle device 100 do not interfere with the outer cup 30A or the inner cup 30B.

Further, when the nozzle device 100 moves in the horizontal direction from the center of the substrate to the outer peripheral end of the substrate, the replacement liquid L3 is discharged in the direction orthogonal to the substrate W over the wide range of the upper surface of the substrate W. At this time, the replacement liquid L3 is discharged from the nozzle upper position HP, so that the replacement liquid L3 collides with the obverse surface of the substrate W with energy larger than the energy with which the replacement liquid is discharged from the nozzle lower position LP. Therefore, the rinse liquid L2 remaining in the grooves on the substrate W is efficiently replaced with the replacement liquid L3 and smoothly removed.

Subsequently, in the post-process of the drying process, the nozzle device 100 is arranged at the nozzle upper position HP, and the first gas injection port 72 is opposite to the center WC of the substrate W. In this state, the first gas is downwardly injected from the first gas injection port 72 of the nozzle device 100. The nozzle device 100 is lowered from the nozzle upper position HP to the nozzle lower position LP while the first gas is kept injected. At this time, a degree of impact generated in a case in which the first gas injected from the first gas injection port 72 collides with the substrate W gradually increases as the nozzle device 100 moves from the nozzle upper position HP to the nozzle lower position LP. Therefore, the change in impact applied to the replacement liquid L3 on the substrate W is alleviated, as compared with a case in which the injection of the first gas is started with the nozzle device 100 located at the nozzle lower position LP. Therefore, splashing of the replacement liquid L3 caused by collision of the first gas with the substrate W is reduced. This suppresses degradation of cleanliness of the substrate W due to re-adherence of the replacement liquid L3 splashed from the substrate W to the substrate W.

Thereafter, with the nozzle device 100 being located at the nozzle lower position LP and with the injection of the first gas continued, the nozzle device 100 is moved in the horizontal direction from the center of the substrate to the outer peripheral end of the substrate. In this case, the first gas blows in the direction orthogonal to the substrate W over the wide range of the upper surface of the substrate W. Thus, the replacement liquid L3 remaining in the large number of grooves on the substrate W is efficiently replaced with the first gas. Therefore, the replacement liquid L3 remaining in the grooves is smoothly removed, and the substrate W is dried. During this drying, because the replacement liquid L3 has a surface tension lower than that of the rinse liquid L2, damage to a pattern (collapse of a pattern, etc.) formed on the substrate W due to the surface tension of the replacement liquid L3 is less likely occur. As a result, it is possible to appropriately remove the rinse liquid L2 remaining on the substrate W after pattern formation.

(d) In a case in which the nozzle device 100 is located in a space above the substrate W, the second gas is injected from the second gas injection port 131. In this case, at a position above the substrate W, a flow of the second gas is formed so as to spread in a planar shape in the direction parallel to the upper surface of the substrate W. This suppresses fall of particles splashing at a position higher than the second gas injection port 131 onto the substrate W. This suppresses degradation of cleanliness of the substrate W after drying.

(e) In a case in which the nozzle device 100 is located in a space above the substrate W, the third gas is injected from the third gas injection port 132 while the second gas is injected from the second gas injection port 131. A flow of the third gas injected from the third gas injection port 132 blocks a flow of gas between a space above the third gas injection port 132 and a space below the third gas injection port 132. Thus, contaminants such as particles are further prevented from falling on the substrate W from the space above the third gas injection port 132.

Further, with the nozzle device 100 having one posture, the third gas injection port 132 is located above the second gas injection port 131. Thus, in a case in which the second gas and the third gas are injected from the nozzle device 100 at the same time, a space lower than the third gas injection port 132 and higher than the substrate W can be filled with the second gas. Therefore, a space surrounding the substrate W can be kept in a clean and low-reactive environment, that is, a chemically stable environment.

### 9. Substrate Processing System Including Substrate Processing Apparatus 1

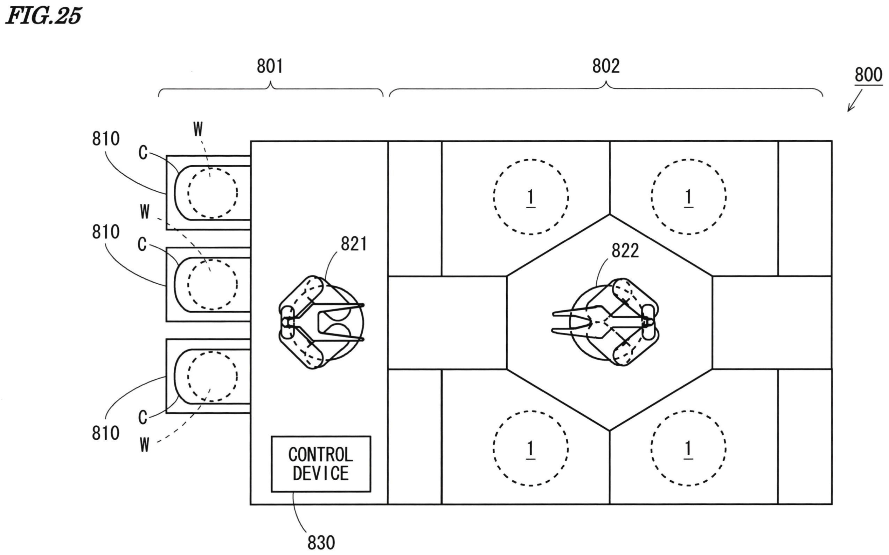

Fig. 25 is a schematic plan view showing one example of a substrate processing system including the substrate processing apparatus 1 of Fig. 1. As shown in Fig. 25, the substrate processing system 800 of the present example includes a substrate carry-in carry-out section 801 and a substrate processing section 802.

In the substrate carry-in carry-out section 801, a plurality (three in the present example) of carrier platforms 810, a transport robot 821 and a control device 830 are provided. In each carrier platform 810, a carrier C for storing a plurality of substrates W is placed. The transport robot 821 includes a plurality (four, for example) of hands, and is configured to be capable of holding and transporting a substrate W. The control device 830 includes a CPU and a memory, or a microcomputer, and controls each constituent element of the substrate processing system 800.

In the substrate processing section 802, a transport robot 822 and a plurality (four in the present example) of substrate processing apparatuses 1 are provided. In plan view, the four substrate processing apparatuses 1 are arranged to surround the transport robot 822. Each of these substrate processing apparatuses 1 is the substrate processing apparatus 1 of Fig. 1. That is, in the substrate processing system 800 of Fig. 25, the substrate processing apparatus 1 of Fig. 1 is provided as one processing unit forming the substrate processing system 800. The transport robot 822 includes a plurality (four, for example) of hands, and is configured to be capable of holding and transporting a substrate W.

In the substrate processing system 800, the transport robot 821 takes out an unprocessed substrate W from any one of a plurality of carriers C placed on the plurality of carrier platforms 810, and transfers the unprocessed substrate W to the transport robot 822. The transport robot 822 transfers the transferred substrate W to one of the plurality of substrate processing apparatuses 1. Thus, in the one substrate processing apparatus 1, a series of above-mentioned processes (the chemical liquid process, the rinsing process and the drying process) is executed.

Further, the transport robot 822 takes out a processed substrate W from one substrate processing apparatus 1 among the plurality of substrate processing apparatuses 1 and transfers the processed substrate W to the transport robot 821. The transport robot 821 receives the processed substrate W and accommodates the substrate W in an empty carrier C.

With each substrate processing apparatus 1, it is possible to process the substrate W with high accuracy while suppressing the consumption of fluid resources (the replacement liquid L3 and the first gas) used for processing the substrate W after pattern formation. Therefore, with the substrate processing system 800, the cost required for processing the substrate W is reduced, and a substrate can be processed with high efficiency and high yield.

### 10. Other Embodiments

(a) While the two divided areas R1, R2 for identifying a plurality of portions are defined in a plurality of portions of the upper surface of the substrate W in the substrate processing apparatus 1 according to the above-mentioned embodiment, the present disclosure is not limited to this. Three or more divided areas arranged in a radial direction of the substrate W may be defined in the upper surface of the substrate W. In this case, the lengths of the plurality of divided areas in the radial direction of the substrate W may be equal to or different from one another.

Further, as described above, in a case in which the three or more divided areas are defined on the substrate W, in a liquid flow-rate condition, the flow rate of a replacement liquid L3 to be supplied to each of the three or more divided areas is defined. Further, in a liquid movement condition, in order to supply the replacement liquid L3 to each of the three or more divided areas, the movement speed of the nozzle device 100 when the nozzle device 100 moves in a space above each divided area of the substrate W is defined.

Further, in a case in which the three or more divided areas are defined on the substrate W, in a liquid flow-rate condition, the flow rate of the first gas to be supplied to each of the three or more divided areas is defined. Further, in a gas movement condition, in order to supply the first gas to each of the three or more divided areas, the movement speed of the nozzle device 100 when the nozzle device 100 moves in a space above each divided area of the substrate W is defined.

A plurality of divided areas do not necessarily have to be defined in the upper surface of the substrate W. In this case, in a liquid flow-rate condition, a plurality of flow rates of the replacement liquid L3 may be set so as to respectively correspond to a plurality of portions of the movement path MP of Fig. 7. Further, in a gas flow-rate condition, a plurality of flow rates of the first gas may be set so as to respectively correspond to a plurality of portions of the movement path MP of Fig. 7. Further, in each of the liquid movement condition and the gas movement condition, a plurality of movement speeds of the nozzle device 100 may be set so as to respectively correspond to a plurality of portions of the movement path MP of Fig. 7.

(b) In the substrate processing apparatus 1 according to the above-mentioned embodiment, the controller 200 may control the rotation driver 22 to adjust the rotation speed of the substrate W when the replacement liquid L3 or the first gas is supplied to each of the plurality of portions (divided areas R1, R2) of the substrate W. For example, the controller 200 may control the rotation driver 22 to rotate the substrate W at a first rotation speed when the replacement liquid L3 or the first gas is supplied to the divided area R1. Further, the substrate W may be rotated at a second rotation speed different from the first rotation speed when the replacement liquid L3 or the first gas is supplied to the divided area R2. In these cases, each of a liquid processing condition and a gas processing condition stored in the storage device 204 may include a condition representing the relationship between the plurality of portions of the substrate W and a rotation speed of the substrate W.

(c) In the above-mentioned embodiment, in a liquid flow-rate condition and a gas flow-rate condition, the flow rate of each fluid corresponding to the center WC of the substrate W and its vicinity is set low and the flow rate of each fluid corresponding to the outer peripheral end of the substrate W and its vicinity is set high. However, the present disclosure is not limited to this. Depending on a pattern formed on the substrate W, in a liquid flow-rate condition and a gas flow-rate condition, the flow rate of each fluid corresponding to the center WC of the substrate W and its vicinity may be set high, and the flow rate of each fluid corresponding to the outer peripheral end of the substrate W and its vicinity may be set low.

(d) In the above-mentioned embodiment, in a liquid movement condition and a gas movement condition, the movement speed corresponding to the center WC of the substrate W and its vicinity is set high and the movement speed corresponding to the outer peripheral end of the substrate W and its vicinity is set low. However, the present disclosure is not limited to this. Depending on a pattern formed on the substrate W, in a liquid movement condition and a gas movement condition, the movement speed corresponding to the center WC of the substrate W and its vicinity may be set low, and the movement speed corresponding to the outer peripheral end of the substrate W and its vicinity may be set high.

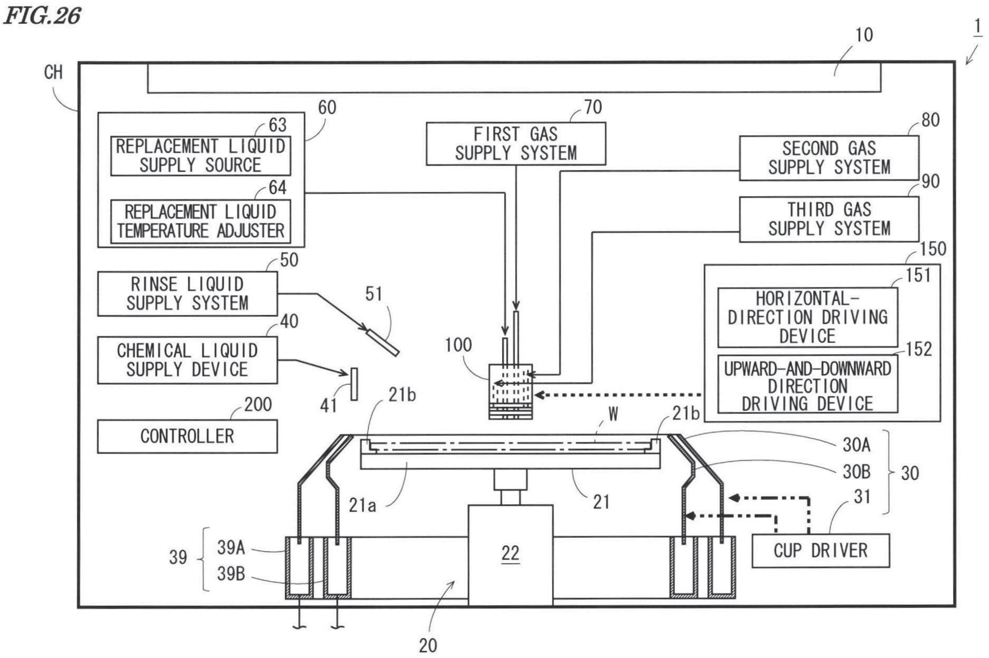

(e) In the substrate processing apparatus 1 according to the above-mentioned embodiment, the replacement liquid supply system 60 may be configured to be capable of supplying the replacement liquid L3 heated to a predetermined temperature to the nozzle device 100. Fig. 26 is a schematic side view of the substrate processing apparatus 1 according to another embodiment. In regard to the configuration and work of the substrate processing apparatus 1 of Fig. 26, the differences from the configuration and work of the substrate processing apparatus 1 of Fig. 1 according to the above-mentioned embodiment will be described.

As shown in Fig. 26, in the substrate processing apparatus 1 of the present example, a replacement liquid supply system 60 includes a replacement liquid supply source 63 and a replacement liquid temperature adjuster 64. The replacement liquid supply source 63 includes a tank or the like storing a replacement liquid L3, for example, and supplies the replacement liquid L3 to the replacement liquid temperature adjuster 64. The replacement liquid temperature adjuster 64 includes a pipe and a heater, for example, and heats the replacement liquid L3 supplied from the replacement liquid supply source 63 to a temperature higher than room temperature (25 °C, for example). Specifically, the replacement liquid temperature adjuster 64 adjusts the temperature of the replacement liquid to about 60 °C to 70 °C, for example, by heating the replacement liquid L3.

In this case, in a pre-process of a drying process, the replacement liquid at about 60 °C to 70 °C can be supplied from the replacement liquid supply system 60 to the nozzle device 100. Thus, a rinse liquid L2 remaining on a substrate W after the rinsing process is replaced with the replacement liquid L3 having a temperature higher than room temperature. Further, the replacement liquid L3 having a temperature higher than room temperature is supplied to the substrate W, so that it is possible to keep the temperature of the substrate W higher than room temperature. This facilitates evaporation of the replacement liquid L3 on the substrate W in the post-process of the drying process, and a period of time required for drying the substrate W can be shortened.

In the substrate processing apparatus 1 of Fig. 26, the controller 200 may control the replacement liquid temperature adjuster 64 to adjust the temperature of the replacement liquid L3 supplied to each of a plurality of portions (divided areas R1, R2) of the substrate W. For example, the controller 200 may control the replacement liquid temperature adjuster 64 to supply the replacement liquid L3 at a first temperature to the divided area R1 and supply the replacement liquid L3 having a second temperature different from the first temperature to the divided area R3.

A specific example will be described. In the substrate processing apparatus 1 of the present example, a temperature adjustment condition is further stored in the storage device 204 (Fig. 6) of the controller 200. The replacement liquid temperature adjuster 64 is controlled based on a temperature adjustment condition stored in the controller 200.

Here, a temperature adjustment condition defines a temperature to be adjusted of the replacement liquid L3 supplied to each of the plurality of portions (divided areas R1, R2) of the substrate W when the replacement liquid L3 is supplied to the substrate W. More specifically, the temperature adjustment condition of the present example defines a temperature of the replacement liquid L3 to be supplied to each portion with the nozzle device 100 being opposite to the portion of the substrate W in a case in which the nozzle device 100 moves along the movement path MP.

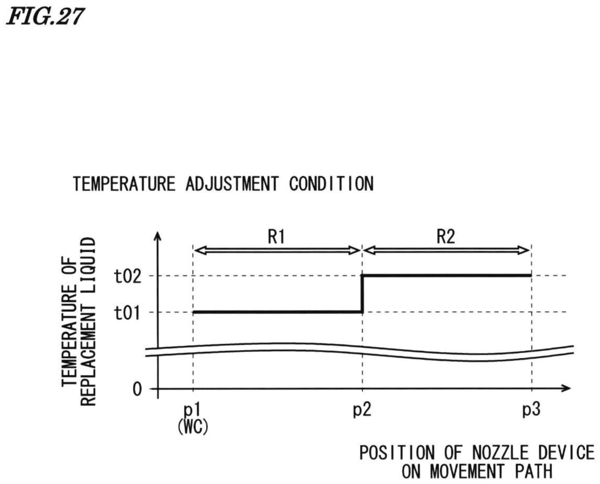

Fig. 27 is a diagram showing one example of a temperature adjustment condition. In Fig. 27, a temperature adjustment condition is shown by a graph. In the graph of Fig. 27, the ordinate indicates a temperature of the replacement liquid L3, and the abscissa indicates a position on the movement path MP of Fig. 7.

According to the temperature adjustment condition of Fig. 27, the temperature of the replacement liquid L3 when the nozzle device 100 is located at a position opposite to the divided area R1 of the substrate W is defined to be kept constant at a first temperature t01. On the other hand, the temperature of the replacement liquid L3 when the nozzle device 100 is located at a position opposite to the divided area R2 of the substrate W is defined to be kept constant at a second temperature t02 higher than the first temperature t01.

In the rotating substrate W, the temperature of the peripheral portion of the substrate W is likely to be lower than that of the center portion of the substrate W. Therefore, when the replacement liquid L3 having a predetermined temperature is supplied from the nozzle device 100 to the divided areas R1, R2, the temperature of the replacement liquid L3 in the divided area R2 is likely to decrease due to the temperature of the substrate W. The lower the temperature of the replacement liquid L3, the lower the efficiency of replacing the rinse liquid L2 with the replacement liquid L3, and the higher the temperature of the replacement liquid L3, the higher the efficiency of replacing the rinse liquid L2 with the replacement liquid L3.

As such, in the temperature adjustment condition of Fig. 27, the temperature of the replacement liquid L3 supplied to the outer peripheral end of the substrate W and its vicinity is set higher than the temperature of the replacement liquid L3 supplied to the center portion of the upper surface of the substrate W. This improves the efficiency of replacing the rinse liquid L2 with the replacement liquid L3 over the entire upper surface of the substrate W. In the temperature adjustment condition of the present example, the first temperature t01 is 65 (°C), for example, and the second temperature t02 is 70 (°C), for example.

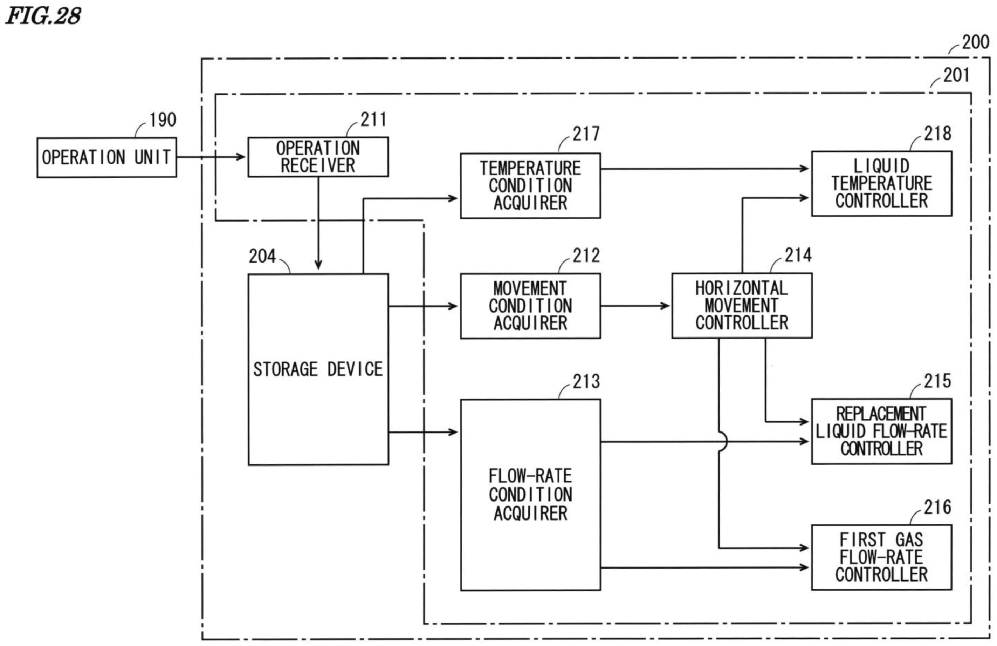

Fig. 28 is a block diagram for explaining one example configuration of the functions for control based on a liquid processing condition, a gas processing condition and a temperature adjustment condition. Differences of the one example configuration of Fig. 28 from the example of Fig. 10 will be described.

As shown in Fig. 28, a CPU 201 of the controller 200 includes a temperature condition acquirer 217 and a liquid temperature controller 218 in addition to the configuration of Fig. 10 as functions for control based on a liquid processing condition, a gas processing condition and a temperature adjustment condition. These functions are implemented by execution by the CPU of the controller 200 of a substrate cleaning program stored in the storage device 204. Part or all of the temperature condition acquirer 217 and the liquid temperature controller 218 may be realized by hardware such as an electronic circuit.

An operation receiver 211 receives a temperature adjustment condition from an operation unit 190. Further, the operation receiver 211 stores the received temperature adjustment condition in the storage device 204.

In a case in which the drying process is executed on the substrate W, the temperature condition acquirer 217 acquires the temperature adjustment condition stored in the storage device 204. Further, the temperature condition acquirer 217 provides the acquired temperature adjustment condition to the liquid temperature controller 218.

The liquid temperature controller 218 receives information representing a position of the nozzle device 100 on the movement path MP from a horizontal movement controller 214. In a case in which the rinse liquid L2 on the substrate W is replaced with the replacement liquid L3 in the drying process for the substrate W, the liquid temperature controller 218 controls the replacement liquid temperature adjuster 64 of Fig. 27 based on the temperature adjustment condition and the information provided from the horizontal movement controller 214. Thus, depending on a position of the nozzle device 100 with respect to the substrate W, the replacement liquid L3 having a temperature according to the temperature adjustment condition is supplied to the nozzle device 100.

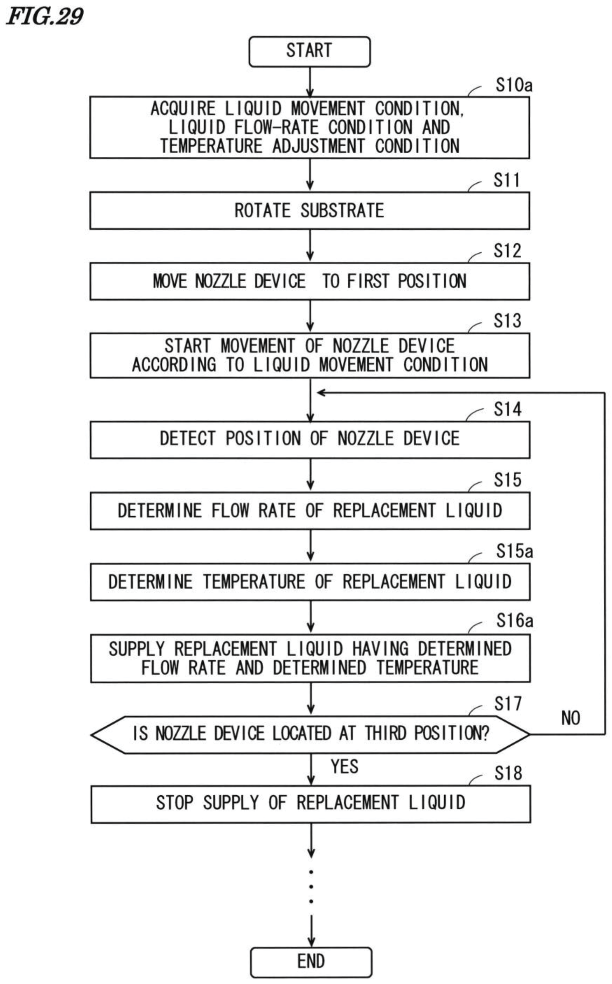

Fig. 29 is a flowchart showing a flow of process by the plurality of functions of Fig. 28. The flow of process executed by the plurality of functions in Fig. 28 is the same as the flow of process shown in the flowcharts of Figs. 11 and 12 except for a portion. Therefore, in Fig. 29, some of the processes common to the processes described in Figs. 11 and 12 are not shown. The differences of the flowchart of Fig. 29 from the examples of Figs. 11 and 12 will be described.

In the present example, when the drying process for the substrate W is started, a movement condition acquirer 212, a flow-rate condition acquirer 213 and a temperature condition acquirer 217 respectively acquire a liquid movement condition, a liquid flow-rate condition and a temperature adjustment condition (step S10a). Next, the controller 200 sequentially executes the steps S11 to S15 of Fig. 11.

Subsequently, the liquid temperature controller 218 determines a temperature of the replacement liquid L3 to be supplied to the nozzle device 100 at a current point in time based on the temperature adjustment condition and the position of the nozzle device 100 detected in the step 14 immediately before the step S15 (step S15a).

Next, the replacement liquid flow-rate controller 215 and the liquid temperature controller 218 control the replacement liquid supply system 60 to supply the replacement liquid L3 to the nozzle device 100 at a determined flow rate and the determined temperature (step S16a). Thereafter, the process of the steps S17 to S28 in Figs. 11 and 12 is executed, and a series of processes ends.

In the temperature adjustment condition of Fig. 27, the temperature of the replacement liquid L3 supplied to the divided area R2 is set higher than the temperature of the replacement liquid L3 supplied to the divided area R1. However, depending on the types of the rinse liquid L2 and the replacement liquid L3, processing environments or the like, the temperature of the replacement liquid L3 supplied to the divided area R2 may be set lower than the temperature of the replacement liquid L3 supplied to the divided area R1.

While the replacement liquid temperature adjuster 64 provided in the replacement liquid supply system 60 adjusts the temperature of the replacement liquid L3 supplied to the substrate W in the substrate processing apparatus 1 of Fig. 26, the temperature of the replacement liquid L3 supplied to the substrate W may be indirectly adjusted via the substrate W.

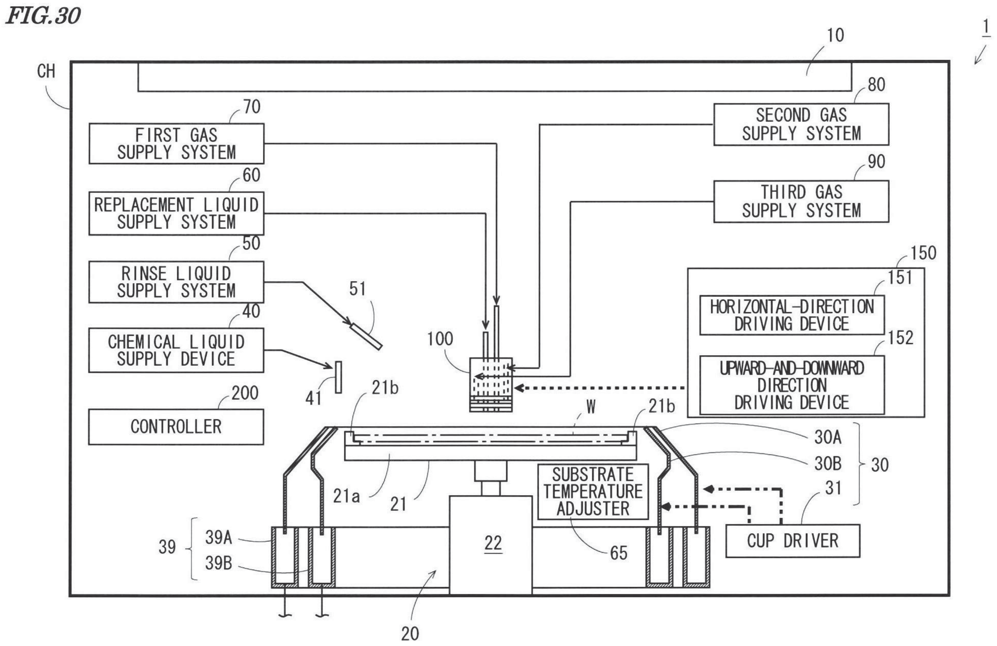

Fig. 30 is a schematic side view of a substrate processing apparatus 1 according to yet another embodiment. The substrate processing apparatus 1 of Fig. 30 has a substrate temperature adjuster 65 instead of the replacement liquid temperature adjuster 64 of Fig. 26. The substrate temperature adjuster 65 is configured to be capable of adjusting a temperature of a substrate W held by a substrate holder 21.

Specifically, the substrate temperature adjuster 65 may be a back rinse device that supplies a processing liquid (pure water, for example) having a temperature higher than room temperature to the peripheral portion of the lower surface of the substrate W held by the substrate holder 21. Alternatively, the substrate temperature adjuster 65 may be a heater that is provided in a spin base 21a and heats at least part of the substrate W, for example. Alternatively, the substrate temperature adjuster 65 may be a liquid supply device that supplies a processing liquid (pure water, for example) having a temperature higher than room temperature to the center portion of the lower surface of the substrate W through the inside of a rotation shaft of a rotation driver 22.

In this case, the temperature adjustment condition may include a condition for controlling the work of the substrate temperature adjuster 65. Thus, a liquid temperature controller 218 of a controller 200 may control the substrate temperature adjuster 65 based on a temperature adjustment condition and a position of the nozzle device 100 on the substrate W. For example, the liquid temperature controller 218 may stop the work of the substrate temperature adjuster 65 when the nozzle device 100 is located at a position opposite to a divided area R1, and may cause the substrate temperature adjuster 65 to work when the nozzle device 100 is located at a position opposite to a divided area R2. Thus, by increasing the temperature of the substrate W only when the nozzle device 100 is located in the divided area R2, for example, it is possible to increase the temperature of a replacement liquid L3 supplied to the substrate W via the substrate W.

Depending on the types of a rinse liquid L2 and the replacement liquid L3, processing environments or the like, the liquid temperature controller 218 may cause the substrate temperature adjuster 65 to work when the nozzle device 100 is located at a position opposite to the divided area R1, and may stop the work of the substrate temperature adjuster 65 when the nozzle device 100 is located at a position opposite to the divided area R2.

(f) While a mechanical chuck-type spin chuck that holds the outer peripheral end of the substrate W is used as the substrate holder 21 in the substrate processing apparatus 1 according to the above-mentioned embodiment, the present disclosure is not limited to this. As the substrate holder 21, a suction-type spin chuck that holds the center portion of the lower surface of the substrate W by suction may be used.

(g) In the substrate processing apparatus 1 according to the above-mentioned embodiment, the cup upper position of the outer cup 30A is the same as the cup upper position of the inner cup 30B, and the cup lower position of the outer cup 30A is the same as the cup lower position of the inner cup 30B. However, the present disclosure is not limited to this. The cup upper position of the outer cup 30A and the cup upper position of the inner cup 30B may be different from each other. Further, the cup lower position of the outer cup 30A and the cup lower position of the inner cup 30B may be different from each other. Further, the outer cup 30A and the inner cup 30B may be configured to be independently movable in the upward-and-downward direction without interfering with each other. In this case, the nozzle upper position HP of the nozzle device 100 is preferably set to a position higher than the upper end portion of the outer cup 30A being located at the cup upper position and the upper end portion of the inner cup 30B being located at the cup upper position.

(h) In the post-process of the drying process according to the above-mentioned embodiment, in order to prevent interference of the nozzle device 100 with the outer cup 30A and the inner cup 30B, the outer cup 30A and the inner cup 30B are lowered from the cup upper position to the cup lower position during the horizontal movement of the nozzle device 100 being located at the nozzle lower position LP. However, the present disclosure is not limited to this.

In a case in which the nozzle device 100 does not interfere with the outer cup 30A or the inner cup 30B being located at the cup upper position even when the first gas is injected from the nozzle device 100 to the outer peripheral end of the substrate W for the reason that the size of the nozzle device 100 is sufficiently small or the like, the outer cup 30A and the inner cup 30B may be held at the cup upper position during the drying process.

In a case in which it is possible to inject the first gas to the entire area in which the pattern is formed on the substrate W because the nozzle device 100 moves horizontally in a range in which the nozzle device 100 does not interfere with the outer cup 30A or the inner cup 30B located at the cup upper position, the range of horizontal movement of the nozzle device 100 may be limited. Alternatively, in a case in which it is possible to sufficiently dry the entire substrate W because the nozzle device 100 moves horizontally in a range in which the nozzle device 100 does not interfere with the outer cup 30A or the inner cup 30B located at the cup upper position, the range of horizontal movement of the nozzle device 100 may be limited. Here, the limitation of the range of horizontal movement of the nozzle device 100 refers to the horizontal movement of the nozzle device 100 in a range in which the nozzle device 100 is moved from the center of the substrate to a position located farther inward than the outer peripheral end of the substrate by a certain distance. In these cases, the outer cup 30A and the inner cup 30B may be held at the cup upper position in the period of the drying process.

(i) While the nozzle device 100 according to the above-mentioned embodiment has the second gas injection port 131 and the third gas injection port 132 formed in the outer peripheral surface 130, the present disclosure is not limited to this. One of the second gas injection port 131 and the third gas injection port 132 does not have to be formed.

(j) In the substrate processing apparatus 1 according to the above-mentioned embodiment, the flow rates of the second gas and the third gas injected from the nozzle device 100 when the first gas is supplied to each of the plurality of portions (the divided areas R1, R2) of the substrate W may be adjusted. A specific example such a substrate processing apparatus 1 will be described.

In the substrate processing apparatus 1 of the present example, a gas emitting condition is further stored in the storage device 204 (Fig. 6) of a controller 200. Based on the gas emitting condition stored in the controller 200, the second gas supply system 80 (Fig. 1) and the third gas supply system 90 (Fig. 1) are controlled.

Here, a gas emitting condition defines the injection flow rates of the second gas and the third gas to be respectively injected from the nozzle device 100 to the plurality of portions (the divided areas R1, R2) of the substrate W when the first gas is supplied to the substrate W. More specifically, a gas emitting condition of the present example defines the flow rates of the second gas and the third gas to be supplied to the nozzle device 100 with the nozzle device 100 being opposite to each portion of the substrate W when the nozzle device 100 moves along the movement path MP.

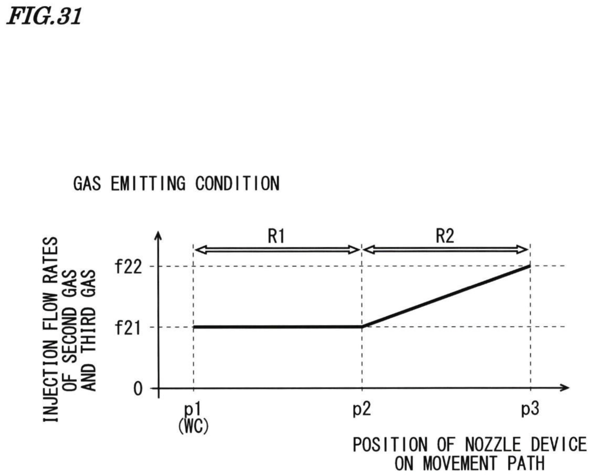

Fig. 31 is a diagram showing one example of a gas emitting condition. In Fig. 31, the gas emitting condition is indicated by a graph. In the graph of Fig. 31, the ordinate indicates injection flow rates of the second gas and the third gas injected from the nozzle device 100, and the abscissa indicates a position on the movement path MP of Fig. 7.

According to the gas emitting condition of Fig. 31, the injection flow rates of the second gas and the third gas when the nozzle device 100 is located at a position opposite to the divided area R1 of the substrate W are defined to be constant at a flow rate f21. On the other hand, the injection flow rates of the second gas and the third gas when the nozzle device 100 is located at a position opposite to the divided area R2 of the substrate W are defined to increase at a constant rate as the nozzle device 100 approaches the third position p3 from the second position p2. Thus, the injection flow rates of the second gas and the third gas when the nozzle device 100 is located at the third position p3 are a flow rate f22 larger than the injection flow rates (flow rate f21) of the second gas and the third gas when the nozzle device 100 is located at the second position p2. In the gas emitting condition of the present example, the flow rate f21 is 72.5 (I/min), for example, and the flow rate f22 is 150 (I/min), for example.

In a case in which the substrate W is dried by injection of the first gas to the divided area R2 including the outer peripheral end of the substrate W, the replacement liquid L3 is likely to splash from the substrate W as compared with a case in which the substrate W is dried by injection of the first gas to the divided area R1 located at the center of the substrate W.

As such, in the gas emitting condition of Fig. 31, the injection flow rates of the second gas and the third gas when the nozzle device 100 is located above the divided area R2 are set higher than the injection flow rates of the second gas and the third gas when the nozzle device 100 is located above the divided area R1. This suppresses leakage of a large amount of droplets splashing from the substrate W in the outer peripheral end of the substrate W and its vicinity into a space above the third gas injection port 132 (Fig. 3). Further, this prevents contaminants and so on floating in a space above the third gas injection port 132 (Fig. 3) from falling onto the substrate W.

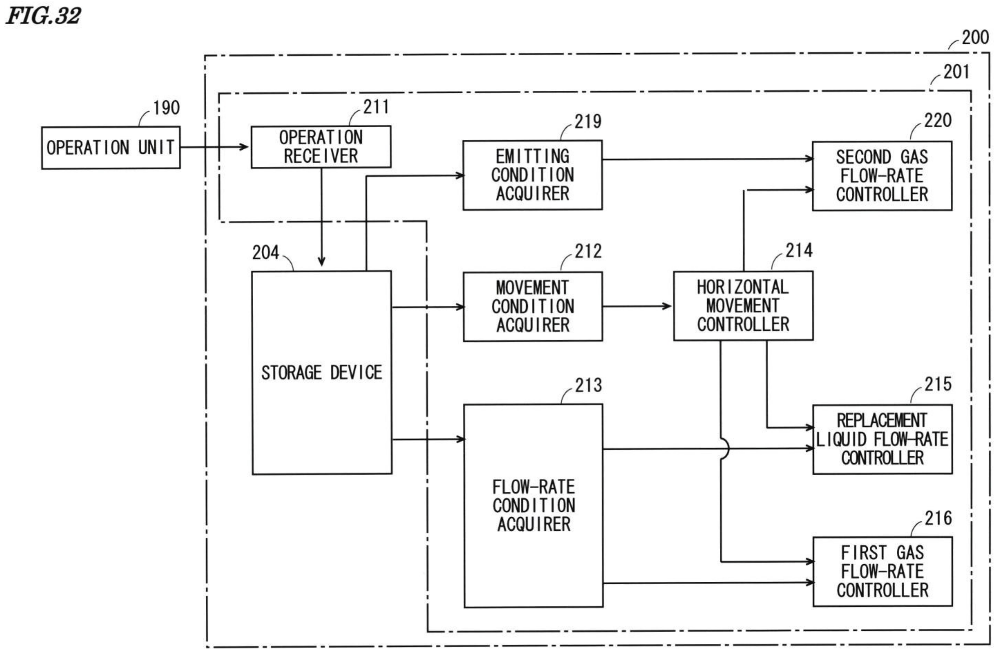

Fig. 32 is a block diagram for explaining one example configuration of the functions for control based on a liquid processing condition, a gas processing condition and a gas emitting condition. The differences of the one example configuration of Fig. 32 from the example of Fig. 10 will be described.

As shown in Fig. 32, a CPU 201 of the controller 200 includes an emitting condition acquirer 219 and a second gas flow-rate controller 220 in addition to the configuration of Fig. 10 as functions for control based on a liquid processing condition, a gas processing condition and a gas emitting condition. These functions are implemented by execution by the CPU of the controller 200 of a substrate cleaning program stored in the storage device 204. Part or all of the emitting condition acquirer 219 and the second gas flow-rate controller 220 may be realized by hardware such as an electronic circuit.

The operation receiver 211 receives a gas emitting condition from the operation unit 190. Further, the operation receiver 211 stores the received gas emitting condition in the storage device 204. In a case in which the drying process is executed on the substrate W, the emitting condition acquirer 219 acquires the gas emitting condition stored in the storage device 204. Further, the emitting condition acquirer 219 provides the acquired gas emitting condition to the second gas flow-rate controller 220.

The information presenting a position of the nozzle device 100 on the movement path MP is provided to the second gas flow-rate controller 220 from the horizontal movement controller 214. In a case in which the replacement liquid L3 on the substrate W is removed in the drying process for the substrate W, the second gas flow-rate controller 220 controls the second gas supply system 80 and the third gas supply system 90 based on the gas emitting condition and the information provided from the horizontal movement controller 214. Thus, depending on a position of the nozzle device 100 with respect to the substrate W, the second gas and the third gas are radially spouted from the second gas injection port 131 and the third gas injection port 132 of the nozzle device 100 at flow rates according to the gas emitting condition.

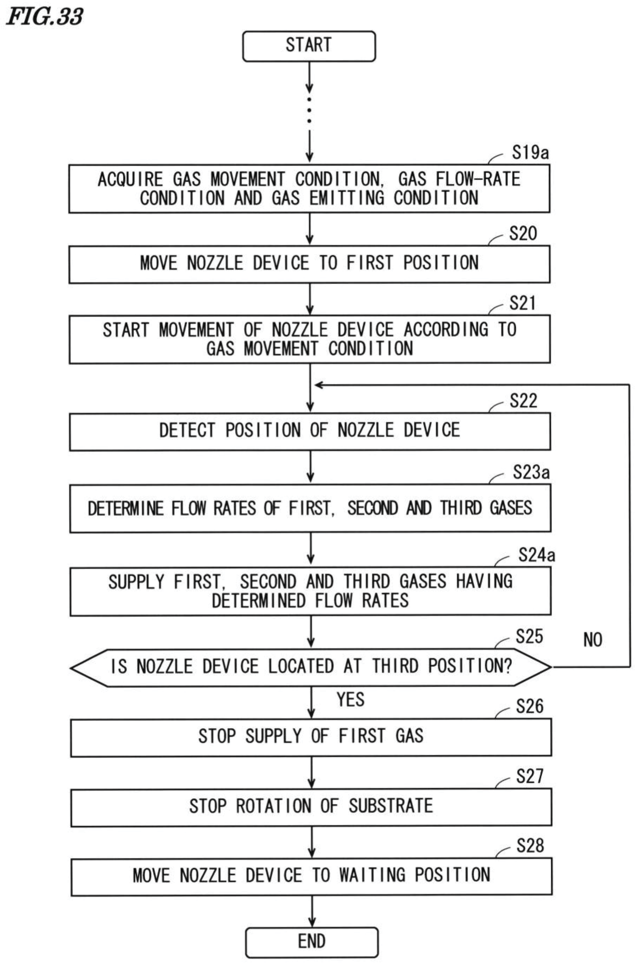

Fig. 33 is a flowchart showing a flow of process by the plurality of functions of Fig. 32. The flow of process executed by the plurality of functions of Fig. 32 is the same as the flow of process shown in the flowcharts of Figs. 11 and 12 except for a portion. Therefore, in Fig. 33, some of the processes common to the processes described in Figs. 11 and 12 are not shown. The differences of the flowchart of Fig. 33 from the examples of Figs. 11 and 12 will be described.

In the present example, when the drying process for the substrate W is started, the process of the steps S10 to S18 of Fig. 11 is executed. Thereafter, the movement condition acquirer 212, the flow-rate condition acquirer 213 and the emitting condition acquirer 219 respectively acquire a liquid movement condition, a liquid flow-rate condition and a gas emitting condition (step S19a). Next, the controller 200 sequentially executes the steps S20 to S22 of Fig. 12.

Subsequently, the first gas flow-rate controller 216 and the second gas flow-rate controller 220 determine the flow rates of the first gas, the second gas and the third gas to be supplied to the nozzle device 100 at a current point in time based on a gas flow-rate condition, a gas emitting condition and a position of the nozzle device 100 detected in the step 22 immediately before the step 23a (step S23a).

Next, the first gas flow-rate controller 216 and the second gas flow-rate controller 220 control the first gas supply system 70, the second gas supply system 80 and the third gas supply system 90 to supply the first gas, the second gas and the third gas to the nozzle device 100 at the determined flow rates (step S24a). Thereafter, the process of the steps S25 to S28 in Figs. 11 and 12 is executed, and a series of processes ends.

In a case in which a rinse liquid on the substrate W is replaced with a replacement liquid in the drying process for the substrate W, the second gas flow-rate controller 220 may control the second gas supply system 80 and the third gas supply system 90 of Fig. 1 according to the gas emitting condition.

Further, the gas emitting condition of Fig. 31 is commonly used for the injection flow rate of the second gas and the injection flow rate of the third gas. However, the gas emitting condition corresponding to the injection flow rate of the second gas and the gas emitting condition corresponding to the injection flow rate of the third gas may be different from each other.

### 11. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the rinse liquid L2 is an example of a residual liquid, the substrate processing apparatus 1 and the substrate processing system 800 are examples of a substrate processing apparatus, the substrate holder 21 is an example of a substrate holder, the rotation driver 22 is an example of a rotation driver, the replacement liquid discharge port 62 is an example of a liquid discharger, the nozzle device 100 is an example of a nozzle device, the replacement liquid L3 is an example of a processing liquid, and the replacement liquid supply system 60 and the first gas supply system 70 are examples of a fluid supply system.

Further, the divided areas R1, R2 of the substrate W are examples of a plurality of portions of a substrate, the nozzle movement device 150 is an example of a movement driver, the controller 200, the horizontal movement controller 214, the replacement liquid flow-rate controller 215 and the first gas flow-rate controller 216 are examples of a controller, the first gas injection port 72 is an example of a first gas injector, the nozzle upper position HP is an example of an upper position, the nozzle lower position LP is an example of a lower position, and the second gas injection port 131 is an example of a second gas injector.

### 12. Overview of Embodiments

(Item 1) A substrate processing apparatus according to item 1 that removes a residual liquid remaining on a substrate after pattern formation from the substrate, includes a rotation driver that rotates a substrate holder holding the substrate, a nozzle device having a liquid discharger, a fluid supply system that supplies a processing liquid to the nozzle device, with the processing liquid having a surface tension lower than that of the residual liquid, a movement driver that moves the nozzle device having one posture to a plurality of different portions in a radial direction of the substrate in plan view while keeping the nozzle device at a position above the substrate held by the substrate holder, and a controller that controls the fluid supply system and the movement driver according to a liquid processing condition, wherein with the nozzle device having the one posture, the liquid discharger is formed to downwardly discharge the processing liquid supplied from the fluid supply system, and the liquid processing condition includes a liquid flow-rate condition that defines a flow rate of the processing liquid to be supplied to the nozzle device in each of the plurality of portions, and a liquid movement condition that defines a movement speed of the nozzle device when the nozzle device moves to each of the plurality of portions in order to supply the processing liquid to each of the plurality of portions of the substrate.

With the substrate processing apparatus, an amount of processing liquid supplied to each of the plurality of portions of the substrate is adjusted. Further, the movement speed of the nozzle device when the nozzle device moves to each of the plurality of portions of the substrate is adjusted. Thus, the residual liquid remaining on the substrate can be appropriately replaced with the processing liquid according to a portion of the substrate. Therefore, it is possible to appropriately remove the residual liquid on the substrate. Further, it is possible to reduce the consumption of the processing liquid. As a result, it is possible to execute a process on the substrate with high accuracy while suppressing the consumption of the fluid resources used for the process for the substrate after pattern formation.

(Item 2) The substrate processing apparatus according to item 1, wherein the nozzle device further may have a first gas injector, the fluid supply system may be configured to supply a first gas to the nozzle device, the first gas injector may be formed to downwardly inject the first gas supplied from the fluid supply system with the nozzle device having the one posture, and the controller may control the fluid supply system and the movement driver such that the first gas is injected onto the substrate from the first gas injector of the nozzle device with the processing liquid present on the substrate held by the substrate holder.

In this case, it is possible to inject the first gas from the nozzle device onto the substrate. Thus, after the residual liquid on the substrate is replaced with the processing liquid, the processing liquid on the substrate can be blown off by injection of the first gas to each portion of the substrate. Thus, the substrate can be dried.

(Item 3) The substrate processing apparatus according to item 2, wherein the controller may control the fluid supply system and the movement driver according to a gas processing condition, and the gas processing condition may include a gas flow-rate condition that defines a flow rate of the first gas to be supplied to the nozzle device in each of the plurality of portions, and a gas movement condition that defines a movement speed of the nozzle device when the nozzle device moves to each of the plurality of portions in order to supply the first gas to each of the plurality of portions of the substrate.

In this case, an amount of the first gas supplied to each of the plurality of portions of the substrate is adjusted. Further, the movement speed of the nozzle device when the nozzle device moves to each of the plurality of portions of the substrate is adjusted. Thus, the processing liquid remaining on the substrate can be appropriately replaced with the first gas according to a portion of the substrate. Therefore, it is possible to appropriately remove the processing liquid on the substrate. Further, it is possible to reduce the consumption of the first gas. As a result, it is possible to execute a process on the substrate with high accuracy while further suppressing the consumption of fluid resources used for a process for a substrate after pattern formation.

(Item 4) The substrate processing apparatus according to item 3, wherein the movement driver may be configured to move the nozzle device having one posture between an upper position and a lower position, with the upper position being higher than the substrate held by the substrate holder by a predetermined distance and with the lower position being lower than the upper position and higher than the substrate, and the controller may control the rotation driver such that the substrate held by the substrate holder rotates, may control, as liquid replacement control, the fluid supply system and the movement driver according to the liquid processing condition with the residual liquid present on the substrate held by the substrate holder, after the liquid replacement control, may perform first gas replacement control for controlling the movement driver such that the nozzle device is located at the upper position and the first gas injector is opposite to a center of the substrate with the processing liquid present on the substrate, after the first gas replacement control, may perform second gas replacement control for controlling the fluid supply system and the movement driver such that the nozzle device is lowered from the upper position to the lower position while the first gas is injected from the first gas injector, and after the second gas replacement control, may perform third gas replacement control for controlling the fluid supply system and the movement driver such that the nozzle device being located at the lower position moves from the center of the substrate to an outer peripheral end of the substrate while the first gas is injected from the first gas injector with the nozzle device located at the lower position.

In this case, due to the liquid replacement control, the residual liquid on the substrate is replaced with the processing liquid. Thereafter, due to the first gas replacement control, the nozzle device is arranged at the upper position, and the first gas injector is opposite to the center of the substrate. In this state, due to the second gas replacement control, gas is downwardly injected from the first gas injector of the nozzle device. The nozzle device is lowered from the upper position to the lower position while gas is kept downwardly injected from the first gas injector. At this time, a degree of impact generated when the first gas injected from the first gas injector collides with the substrate gradually increases as the nozzle device is moved from the upper position to the lower position. Therefore, as compared with a case in which the injection of the first gas is started with the nozzle device located at the lower position, a change in impact applied to the processing liquid on the substrate is alleviated. Therefore, splashing of the processing liquid caused by collision of the first gas with the substrate is reduced. This suppresses degradation of cleanliness of the substrate due to re-adherence of the processing liquid splashed from the substrate to the substrate.

On the substrate on which the pattern is formed, a plurality of grooves having a depth in the direction orthogonal to the substrate are formed. With the above-mentioned configuration, because the third gas replacement control is performed, it is possible to inject the first gas to the substrate in the direction orthogonal to the substrate over the wide range of the upper surface of the substrate. Thus, the processing liquid remaining in the grooves on the substrate is more efficiently replaced with the first gas. Therefore, the processing liquid remaining in the grooves is smoothly removed, and the substrate is dried. During this drying, because the processing liquid removed from the substrate has a surface tension lower than that of the residual liquid, damage to the pattern formed on the substrate caused by the surface tension is unlikely to occur. As a result, it is possible to appropriately remove the residual liquid remaining on the substrate after pattern formation from the substrate.

(Item 5) The substrate processing apparatus according to item 4, wherein the third gas replacement control may include control of the fluid supply system and the movement driver by the controller according to the gas processing condition.

In this case, the substrate can be appropriately dried in the third gas replacement control. Further, it is possible to reduce the consumption of the first gas. That is, it is possible to execute a process on the substrate with high accuracy while further suppressing the consumption of fluid resources used for the process for the substrate after pattern formation.

(Item 6) The substrate processing apparatus according to item 4 or 5, wherein the nozzle device may further have a second gas injector, the fluid supply system may be configured to supply a second gas to the nozzle device, the second gas injector may be formed to radially inject the second gas supplied from the fluid supply system toward an outer peripheral end of the substrate in plan view with the nozzle device having the one posture and being arranged in a space above the substrate held by the substrate holder, and the controller may further control the fluid supply system such that the second gas is injected from the second gas injector in a period during which the second gas replacement control and the third gas replacement control are performed.

In this case, in a period during which the second gas replacement control and the third gas replacement control are performed, a flow of the second gas is formed to spread in a planar shape in a direction parallel to the upper surface of the substrate at a position above the substrate. This suppresses fall of particles splashed at a position higher than the second gas injector onto the substrate. This suppresses degradation of cleanliness of the substrate after drying.

(Item 7) A substrate processing apparatus according to item 7 that removes a processing liquid remaining on a substrate after pattern formation and dries the substrate, includes a rotation driver that rotates a substrate holder holding the substrate, a nozzle device having a first gas injector, a fluid supply system that supplies a first gas to the nozzle device, a movement driver that moves the nozzle device having one posture to a plurality of different portions in a radial direction of the substrate in plan view while keeping the nozzle device at a position above the substrate held by the substrate holder, and a controller that controls the fluid supply system and the movement driver according to a gas processing condition, wherein the first gas injector is formed to downwardly inject the first gas supplied from the fluid supply system with the nozzle device having the one posture, and the gas processing condition includes a gas flow-rate condition that defines a flow rate of the first gas to be supplied to the nozzle device in each of the plurality of portions, and a gas movement condition that defines a movement speed of the nozzle device when the nozzle device moves to each of the plurality of portions in order to supply the first gas to each of the plurality of portions of the substrate.

With the substrate processing apparatus, an amount of the first gas supplied to each of the plurality of portions of the substrate is adjusted. Further, the movement speed of the nozzle device when the nozzle device moves to each of the plurality of portions of the substrate is adjusted. Thus, the processing liquid remaining on the substrate can be appropriately blown off by the first gas according to a portion of the substrate. Therefore, it is possible to appropriately remove the processing liquid on the substrate. Further, it is possible to reduce the consumption of the first gas. As a result, it is possible to execute a process on the substrate with high accuracy while suppressing the consumption of the fluid resources used for the process for the substrate after pattern formation.

(Item 8) The substrate processing apparatus according to item 7, wherein the processing liquid may be used to remove a residual liquid remaining on the substrate after pattern formation, and may have a surface tension lower than that of the residual liquid, the movement driver may be configured to move the nozzle device having one posture between an upper position and a lower position, with the upper position being higher than the substrate held by the substrate holder by a predetermined distance and with the lower position being lower than the upper position and higher than the substrate, and the controller may control the rotation driver such that the substrate held by the substrate holder rotates, may perform first gas replacement control for controlling the movement driver such that the nozzle device is located at the upper position and the first gas injector is opposite to a center of the substrate with a processing liquid present on the substrate and with the processing liquid replacing the residual liquid, after the first gas replacement control, may perform second gas replacement control for controlling the fluid supply system and the movement driver such that the nozzle device is lowered from the upper position to the lower position while the first gas is injected from the first gas injector, and after the second gas replacement control, may control, as third gas replacement control, the fluid supply system and the movement driver according to the gas processing condition with the nozzle device located at the lower position.

In this case, due to the first gas replacement control, the nozzle device is arranged at the upper position, and the first gas injector is opposite to the center of the substrate. In this state, due to the second gas replacement control, gas is downwardly injected from the first gas injector of the nozzle device. The nozzle device is lowered from the upper position to the lower position while gas is kept downwardly injected from the first gas injector. At this time, a degree of impact generated when the first gas injected from the first gas injector collides with the substrate gradually increases as the nozzle device is moved from the upper position to the lower position. Therefore, as compared with a case in which injection of the first gas is started with the nozzle device located at the lower position, a change in impact applied to the processing liquid on the substrate is alleviated. Therefore, splashing of the processing liquid caused by collision of the first gas with the substrate is reduced. This suppresses degradation of cleanliness of the substrate due to re-adherence of the processing liquid splashed from the substrate to the substrate.

On the substrate on which the pattern is formed, a plurality of grooves having a depth in the direction orthogonal to the substrate are formed. With the above-mentioned configuration, because the third gas replacement control is performed, it is possible to inject the first gas to the substrate in the direction orthogonal to the substrate over the wide range of the upper surface of the substrate. Thus, the processing liquid remaining in the grooves on the substrate is more efficiently replaced with the first gas. Therefore, the processing liquid remaining in the grooves is smoothly removed, and the substrate is dried. During this drying, because the processing liquid removed from the substrate has a surface tension lower than that of the residual liquid, damage to the pattern formed on the substrate caused by the surface tension is unlikely to occur. As a result, it is possible to appropriately remove the residual liquid remaining on the substrate after pattern formation from the substrate.

(Item 9) The substrate processing apparatus according to item 8, wherein the nozzle device may further have a liquid discharger, the fluid supply system may be configured to supply the processing liquid to the nozzle device, with the nozzle device having the one posture, the liquid discharger may be formed to downwardly discharge the processing liquid supplied from the fluid supply system, and the controller may perform liquid replacement control for controlling the fluid supply system and the movement driver such that the processing liquid is discharged onto the substrate from the liquid discharger of the nozzle device with the residual liquid present on the substrate held by the substrate holder, and after the liquid replacement control, may perform the first gas replacement control.

In this case, the processing liquid can be discharged from the nozzle device onto the substrate. Thus, the residual liquid on the substrate can be replaced with the processing liquid. Thereafter, it is possible to blow off the processing liquid on the substrate by injecting the first gas to each portion of the substrate. Thus, the substrate can be dried.

(Item 10) The substrate processing apparatus according to item 9, wherein the controller may control the fluid supply system and the movement driver according to a liquid processing condition to perform the liquid replacement control, and the liquid processing condition may include a liquid flow-rate condition that defines a flow rate of the processing liquid to be supplied to the nozzle device in each of the plurality of portions, and a liquid movement condition that defines a movement speed of the nozzle device when the nozzle device moves to each of the plurality of portions in order to supply the processing liquid to each of the plurality of portions of the substrate.

In this case, an amount of the processing liquid supplied to each of the plurality of portions of the substrate is adjusted. Further, the movement speed of the nozzle device when the nozzle device moves to each of the plurality of portions of the substrate is adjusted. Thus, the residual liquid remaining on the substrate can be appropriately replaced with the processing liquid according to a portion of the substrate. Therefore, it is possible to appropriately remove the residual liquid on the substrate. Further, it is possible to reduce the consumption of the processing liquid. As a result, it is possible to execute a process on the substrate with high accuracy while further suppressing the consumption of fluid resources used for the process for the substrate after pattern formation.

(Item 11) The substrate processing apparatus according to any one of items 8 to 10, wherein the nozzle device further has a second gas injector, the fluid supply system may be configured to supply a second gas to the nozzle device, the second gas injector may be formed to radially inject the second gas supplied from the fluid supply system toward an outer peripheral end of the substrate in plan view with the nozzle device having the one posture and being arranged in a space above the substrate held by the substrate holder, and the controller may further control the fluid supply system such that the second gas is injected from the second gas injector in a period during which the second gas replacement control and the third gas replacement control are performed.

In this case, in a period during which the second gas replacement control and the third gas replacement control are performed, a flow of the second gas is formed to spread in a planar shape in a direction parallel to the upper surface of the substrate at a position above the substrate. This suppresses fall of particles splashed at a position higher than the second gas injector onto the substrate. This suppresses degradation of cleanliness of the substrate after drying.

(Item 12) A substrate processing method according to item 12 of removing a residual liquid from a substrate using a nozzle device, with the residual liquid remaining on the substrate after pattern formation, wherein the nozzle device has a liquid discharger, the liquid discharger is formed to downwardly discharge a processing liquid supplied to the nozzle device with the nozzle device having one posture, the processing liquid has a surface tension lower than that of the residual liquid, the substrate processing method includes the steps of holding and rotating the substrate using a substrate holder, and according to a liquid processing condition, moving the nozzle device having the one posture to a plurality of different portions in a radial direction of the substrate in plan view and supplying the processing liquid to the plurality of portions of the substrate while keeping the nozzle device at a position above the substrate held by the substrate holder, and the liquid processing condition includes a liquid flow-rate condition that defines a flow rate of a processing liquid to be supplied to the nozzle device in each of the plurality of portions, and a liquid movement condition that defines a movement speed of the nozzle device when the nozzle device moves to each of the plurality of portions in order to supply a processing liquid to each of the plurality of portions of the substrate.

With the substrate processing method, an amount of the processing liquid supplied to each of the plurality of portions of the substrate is adjusted. Further, the movement speed of the nozzle device when the nozzle device moves to each of the plurality of portions of the substrate is adjusted. Thus, the residual liquid remaining on the substrate can be appropriately replaced with the processing liquid according to a portion of the substrate. Therefore, it is possible to appropriately remove the residual liquid on the substrate. Further, it is possible to reduce the consumption of the processing liquid. As a result, it is possible to execute a process on the substrate with higher accuracy while suppressing the consumption of the fluid resources used for the process for the substrate after pattern formation.

(Item 13) A substrate processing method according to item 13 of removing a processing liquid and drying a substrate using a nozzle device, with the processing liquid remaining on the substrate after pattern formation, wherein the nozzle device has a gas injector, the gas injector is formed to downwardly inject a first gas supplied to the nozzle device with the nozzle device having one posture, the substrate processing method includes the steps of holding and rotating the substrate using a substrate holder, and according to a gas processing condition, moving the nozzle device having the one posture to a plurality of different portions in a radial direction of the substrate in plan view and injecting the first gas to the plurality of portions of the substrate while keeping the nozzle device at a position above the substrate held by the substrate holder, and the gas processing condition includes a gas flow-rate condition that defines a flow rate of the first gas to be supplied to the nozzle device in each of the plurality of portions, and a gas movement condition that defines a movement speed of the nozzle device when the nozzle device moves to each of the plurality of portions in order to supply the first gas to each of the plurality of portions of the substrate.

With the substrate processing apparatus, an amount of the first gas supplied to each of the plurality of portions of the substrate is adjusted. Further, the movement speed of the nozzle device when the nozzle device moves to each of the plurality of portions of the substrate is adjusted. Thus, the processing liquid remaining on the substrate can be appropriately blown off by the first gas according to a portion of the substrate. Therefore, it is possible to appropriately remove the processing liquid on the substrate. Further, it is possible to reduce the consumption of the first gas. As a result, it is possible to execute a process on the substrate with high accuracy while suppressing the consumption of the fluid resources used for the process for the substrate after pattern formation.

(Item 14) The substrate processing apparatus according to any one of items 1 to 6, further includes a temperature adjuster that adjusts a temperature of the processing liquid discharged from the nozzle device to the substrate held by the substrate holder or a temperature of the processing liquid on the substrate, wherein the controller may control the temperature adjuster according to a temperature adjustment condition that defines a temperature to which a temperature of the processing liquid is to be adjusted, with the processing liquid being supplied to each of the plurality of portions.

In this case, an amount of the processing liquid supplied to the plurality of portions of the substrate is adjusted. Therefore, the processing liquid adjusted to have an appropriate temperature can be supplied to each of the plurality of portions of the substrate. As a result, improvement of efficiency of processing the substrate, and the like are realized.

(Item 15) The substrate processing apparatus according to item 6, wherein the controller may further control the fluid supply system according to a gas emitting condition that defines a flow rate of the second gas to be supplied to the nozzle device in each of the plurality of portions.

In this case, when the nozzle device is located in the plurality of portions of the substrate, the flow rate of the second gas radially injected from the nozzle device is adjusted. That is, according to a position of the nozzle device on the substrate, a degree of effect obtained by injection of the second gas is appropriately adjusted. Therefore, it is possible to suppress degradation of cleanliness of the substrate after drying while suppressing waste of the second gas.

(Item 16) The substrate processing apparatus according to item 9 or 10, further includes a temperature adjuster that adjusts a temperature of the processing liquid discharged from the nozzle device to the substrate held by the substrate holder or a temperature of the processing liquid on the substrate, wherein the controller may control the temperature adjuster according to a temperature adjustment condition that defines a temperature to which a temperature of the processing liquid is to be adjusted, with the processing liquid being supplied to each of the plurality of portions.

In this case, an amount of the processing liquid supplied to the plurality of portions of the substrate is adjusted. Therefore, the processing liquid adjusted to have an appropriate temperature can be supplied to each of the plurality of portions of the substrate. As a result, improvement of efficiency of processing the substrate, and the like are realized.

(Item 17) The substrate processing apparatus according to item 11, wherein the controller may control the fluid supply system according to a gas emitting condition that defines a flow rate of the second gas to be supplied to the nozzle device in each of the plurality of portions.

In this case, when the nozzle device is located in the plurality of portions of the substrate, the flow rate of the second gas radially injected from the nozzle device is adjusted. That is, according to a position of the nozzle device on the substrate, a degree of effect obtained by injection of the second gas is appropriately adjusted. Therefore, it is possible to suppress degradation of cleanliness of the substrate after drying while suppressing waste of the second gas.

## Claims

1. A substrate processing apparatus that removes a residual liquid remaining on a substrate after pattern formation from the substrate, comprising:
a rotation driver that rotates a substrate holder holding the substrate;
a nozzle device having a liquid discharger;
a fluid supply system that supplies a processing liquid to the nozzle device, the processing liquid having a surface tension lower than that of the residual liquid;
a movement driver that moves the nozzle device having one posture to a plurality of different portions in a radial direction of the substrate in plan view while keeping the nozzle device at a position above the substrate held by the substrate holder; and
a controller that controls the fluid supply system and the movement driver according to a liquid processing condition, wherein
with the nozzle device having the one posture, the liquid discharger is formed to downwardly discharge the processing liquid supplied from the fluid supply system, and
the liquid processing condition includes
a liquid flow-rate condition that defines a flow rate of the processing liquid to be supplied to the nozzle device in each of the plurality of portions, and
a liquid movement condition that defines a movement speed of the nozzle device when the nozzle device moves to each of the plurality of portions in order to supply the processing liquid to each of the plurality of portions of the substrate.

2. The substrate processing apparatus according to claim 1, wherein
the nozzle device further has a first gas injector,
the fluid supply system is configured to supply a first gas to the nozzle device,
the first gas injector is formed to downwardly inject the first gas supplied from the fluid supply system with the nozzle device having the one posture, and
the controller
controls the fluid supply system and the movement driver such that the first gas is injected onto the substrate from the first gas injector of the nozzle device with the processing liquid present on the substrate held by the substrate holder.

3. The substrate processing apparatus according to claim 2, wherein
the controller controls the fluid supply system and the movement driver according to a gas processing condition, and
the gas processing condition includes
a gas flow-rate condition that defines a flow rate of the first gas to be supplied to the nozzle device in each of the plurality of portions, and
a gas movement condition that defines a movement speed of the nozzle device when the nozzle device moves to each of the plurality of portions in order to supply the first gas to each of the plurality of portions of the substrate.

4. The substrate processing apparatus according to claim 3, wherein
the movement driver is configured to move the nozzle device having one posture between an upper position and a lower position, with the upper position being higher than the substrate held by the substrate holder by a predetermined distance and with the lower position being lower than the upper position and higher than the substrate, and
the controller
controls the rotation driver such that the substrate held by the substrate holder rotates,
controls, as liquid replacement control, the fluid supply system and the movement driver according to the liquid processing condition with the residual liquid present on the substrate held by the substrate holder,
after the liquid replacement control, performs first gas replacement control for controlling the movement driver such that the nozzle device is located at the upper position and the first gas injector is opposite to a center of the substrate with the processing liquid present on the substrate,
after the first gas replacement control, performs second gas replacement control for controlling the fluid supply system and the movement driver such that the nozzle device is lowered from the upper position to the lower position while the first gas is injected from the first gas injector, and
after the second gas replacement control, performs third gas replacement control for controlling the fluid supply system and the movement driver such that the nozzle device being located at the lower position moves from the center of the substrate to an outer peripheral end of the substrate while the first gas is injected from the first gas injector with the nozzle device located at the lower position.

5. The substrate processing apparatus according to claim 4, wherein
the third gas replacement control includes control of the fluid supply system and the movement driver by the controller according to the gas processing condition.

6. The substrate processing apparatus according to claim 4 or 5, wherein
the nozzle device further has a second gas injector,
the fluid supply system is configured to supply a second gas to the nozzle device,
the second gas injector is formed to radially inject the second gas supplied from the fluid supply system toward an outer peripheral end of the substrate in plan view with the nozzle device having the one posture and being arranged in a space above the substrate held by the substrate holder, and
the controller further controls the fluid supply system such that the second gas is injected from the second gas injector in a period during which the second gas replacement control and the third gas replacement control are performed.

7. A substrate processing apparatus that removes a processing liquid remaining on a substrate after pattern formation and dries the substrate, comprising:
a rotation driver that rotates a substrate holder holding the substrate;
a nozzle device having a first gas injector;
a fluid supply system that supplies a first gas to the nozzle device;
a movement driver that moves the nozzle device having one posture to a plurality of different portions in a radial direction of the substrate in plan view while keeping the nozzle device at a position above the substrate held by the substrate holder; and
a controller that controls the fluid supply system and the movement driver according to a gas processing condition, wherein
the first gas injector is formed to downwardly inject the first gas supplied from the fluid supply system with the nozzle device having the one posture, and
the gas processing condition includes
a gas flow-rate condition that defines a flow rate of the first gas to be supplied to the nozzle device in each of the plurality of portions, and
a gas movement condition that defines a movement speed of the nozzle device when the nozzle device moves to each of the plurality of portions in order to supply the first gas to each of the plurality of portions of the substrate.

8. The substrate processing apparatus according to claim 7, wherein
the processing liquid is used to remove a residual liquid remaining on the substrate after pattern formation, and has a surface tension lower than that of the residual liquid,
the movement driver is configured to move the nozzle device having one posture between an upper position and a lower position, with the upper position being higher than the substrate held by the substrate holder by a predetermined distance and with the lower position being lower than the upper position and higher than the substrate, and
the controller
controls the rotation driver such that the substrate held by the substrate holder rotates,
performs first gas replacement control for controlling the movement driver such that the nozzle device is located at the upper position and the first gas injector is opposite to a center of the substrate with a processing liquid present on the substrate and with the processing liquid replacing the residual liquid,
after the first gas replacement control, performs second gas replacement control for controlling the fluid supply system and the movement driver such that the nozzle device is lowered from the upper position to the lower position while the first gas is injected from the first gas injector, and
after the second gas replacement control, controls, as third gas replacement control, the fluid supply system and the movement driver according to the gas processing condition with the nozzle device located at the lower position.

9. The substrate processing apparatus according to claim 8, wherein
the nozzle device further has a liquid discharger,
the fluid supply system is configured to supply the processing liquid to the nozzle device,
with the nozzle device having the one posture, the liquid discharger is formed to downwardly discharge the processing liquid supplied from the fluid supply system, and
the controller
performs liquid replacement control for controlling the fluid supply system and the movement driver such that the processing liquid is discharged onto the substrate from the liquid discharger of the nozzle device with the residual liquid present on the substrate held by the substrate holder, and
after the liquid replacement control, performs the first gas replacement control.

10. The substrate processing apparatus according to claim 9, wherein
the controller controls the fluid supply system and the movement driver according to a liquid processing condition to perform the liquid replacement control, and
the liquid processing condition includes
a liquid flow-rate condition that defines a flow rate of the processing liquid to be supplied to the nozzle device in each of the plurality of portions, and
a liquid movement condition that defines a movement speed of the nozzle device when the nozzle device moves to each of the plurality of portions in order to supply the processing liquid to each of the plurality of portions of the substrate.

11. The substrate processing apparatus according to any one of claims 8 to 10, wherein
the nozzle device further has a second gas injector,
the fluid supply system is configured to supply a second gas to the nozzle device,
the second gas injector is formed to radially inject the second gas supplied from the fluid supply system toward an outer peripheral end of the substrate in plan view with the nozzle device having the one posture and being arranged in a space above the substrate held by the substrate holder, and
the controller
further controls the fluid supply system such that the second gas is injected from the second gas injector in a period during which the second gas replacement control and the third gas replacement control are performed.

12. A substrate processing method of removing a residual liquid from a substrate using a nozzle device, the residual liquid remaining on the substrate after pattern formation, wherein
the nozzle device has a liquid discharger,
the liquid discharger is formed to downwardly discharge a processing liquid supplied to the nozzle device with the nozzle device having one posture,
the processing liquid has a surface tension lower than that of the residual liquid,
the substrate processing method includes the steps of
holding and rotating the substrate using a substrate holder, and
according to a liquid processing condition, moving the nozzle device having the one posture to a plurality of different portions in a radial direction of the substrate in plan view and supplying the processing liquid to the plurality of portions of the substrate while keeping the nozzle device at a position above the substrate held by the substrate holder, and
the liquid processing condition includes
a liquid flow-rate condition that defines a flow rate of a processing liquid to be supplied to the nozzle device in each of the plurality of portions, and
a liquid movement condition that defines a movement speed of the nozzle device when the nozzle device moves to each of the plurality of portions in order to supply a processing liquid to each of the plurality of portions of the substrate.

13. A substrate processing method of removing a processing liquid and drying a substrate using a nozzle device, the processing liquid remaining on the substrate after pattern formation, wherein
the nozzle device has a gas injector,
the gas injector is formed to downwardly inject a first gas supplied to the nozzle device with the nozzle device having one posture,
the substrate processing method includes the steps of
holding and rotating the substrate using a substrate holder, and
according to a gas processing condition, moving the nozzle device having the one posture to a plurality of different portions in a radial direction of the substrate in plan view and injecting the first gas to the plurality of portions of the substrate while keeping the nozzle device at a position above the substrate held by the substrate holder, and
the gas processing condition includes
a gas flow-rate condition that defines a flow rate of the first gas to be supplied to the nozzle device in each of the plurality of portions, and
a gas movement condition that defines a movement speed of the nozzle device when the nozzle device moves to each of the plurality of portions in order to supply the first gas to each of the plurality of portions of the substrate.
